# EUROPEAN PATENT SPECIFICATION

(11) **EP 3 094 760 B1**
(45) Date of publication and mention of the grant of the patent: **04.04.2018**
(21) Application number: 15700239.5
(22) Date of filing: 13.01.2015
(51) Int. Cl.: C23C 14/06, C23C 14/28, C23C 14/04

(54) **LASER DIRECT SYNTHESIS AND DEPOSIT OF NANOCOMPOSITE MATERIALS OR NANOSTRUCTURES**
LASERDIREKTSYNTHESE UND ABSCHEIDUNG VON NANOVERBUNDWERKSTOFFEN ODER NANOSTRUKTUREN
SYNTHÈSE DIRECTE AU LASER ET DÉPÔT DE MATÉRIAUX NANOCOMPOSITES OU DE NANOSTRUCTURES

(30) Priority: 15.01.2014 EP 14151331
(43) Date of publication of application: 23.11.2016
(73) Proprietor: Nanotechplasma SARL, 1204 Genève (CH)
(72) Inventor: SERBEZOV, Valery, 4000 Plovdiv (BG)
(74) Representative: KATZAROV S.A.
(86) International application number: PCT/EP2015/050506
(87) International publication number: WO 2015/107051

(56) References cited:
- US-A- 4 970 196
- US-A- 6 025 110
- US-A1- 2003 157 271
- US-A1- 2004 247 777
- US-A1- 2013 011 440
- US-A1- 2013 017 564
- LACHMANN K ET AL: "Development of a multifunctional coating system for laser-induced material transport", PROGRESS IN ORGANIC COATINGS, ELSEVIER BV, NL, vol. 64, no. 2-3, 1 February 2009 (2009-02-01), pages 294-299, XP025884333, ISSN: 0300-9440, DOI: 10.1016/J.PORGCOAT.2008.09.012 [retrieved on 2008-11-11]
- WU P K ET AL: "The deposition, structure, pattern deposition, and activity of biomaterial thin-films by matrix-assisted pulsed-laser evaporation (MAPLE) and MAPLE direct write", THIN SOLID FILMS, ELSEVIER-SEQUOIA S.A. LAUSANNE, CH, vol. 398-399, 1 November 2001 (2001-11-01) , pages 607-614, XP004328744, ISSN: 0040-6090, DOI: 10.1016/S0040-6090(01)01347-5

## Description

### FIELD OF THE INVENTION

The present invention relates to a method for laser assisted synthesis/formation of functional nanocomposite materials or nanostructures and contactless direct transfer/deposit and/or writing thereof in one step and one technological cycle on to different types of receiving substrates.

### BACKGROUND OF THE INVENTION

The nanocomposites and hybrid nanocomposite materials are novel modern materials, which exhibit unique properties of each component that form hybrids and create new alternative with unusual feature on materials. The potential applications of nanocomposites cover many areas as optics, electronics, medicine, pharmacy, mechanics and energy, automotive, defence and aerospace industries. Modern industries require the development of both new nanocomposite materials and technologies for their market realization.

Recently for the deposition of a thin nanocomposite films, materials are applied to a substrate by various methods of thin-film technology to be thereafter processed or structured. The deposition of the coatings is mainly performed using physical vapour deposition (PVD), chemical vapour deposition (CVD) or hybrid techniques, such as LaserArc, Laser-CVD et al. PVD techniques refers to vacuum-based coating methods of thin-film technology wherein coatings are formed directly by condensation of a material vapour of the film material. The PVD group includes thermal evaporation, electron beam evaporation, laser beam evaporation (pulsed laser deposition- PLD, pulsed laser ablation), vacuum arc evaporation, Arc-PVD, molecular beam epitaxy, sputtering (cathode evaporation), ion beam deposition (IBD), as well as ion plating. The following discussion is limited to physical vapour deposition. Characteristic of all these methods is that the material or materials to be deposited is present in solid form in a usually evacuated-vacuum coating chamber. The thin layers or nanocomposites synthesized as coatings onto substrate by a variety of mechanisms of release of the material in a solid phase as called the target. Common to all these methods is that the material/target is destroyed by interaction with laser beams, magnetically deflected ions or electrons, or by arc discharge. The flows of neutral atoms, molecules, ions and electrons are directed to the substrate and synthesize new coatings. To synthesize nanocomposite coatings require very strict control of many parameters included interaction with target or targets, parameters of the environment, substrate parameters, which are major shortcomings of these methods. Other drawbacks of these methods are low rate of formation of nanocomposite coatings and synthesis problems at forming hybrid nanocomposite coatings by one step and in one technological cycle, which are in connection with the different energetic requirements for interaction between laser beam with laser beams, magnetically deflected ions or electrons, or by arc discharge and organic or inorganic substance for transferring the material onto substrate without damages of their functionality. These methods mainly provide inorganic-inorganic nanocomposite coatings, which is disadvantage also. The shortcomings of these methods are described in V. Serbezov, "Pulsed Laser Deposition: The Road to Hybrid Nanocomposites Coatings and Novel Pulsed Laser Adaptive Technique", Recent Patents on Nanotechnology, 2013, 7, 26-40.

In patent application DE 10 2009 031 768 A1 (also US 2013/0011440 A1) is disclosed PVD method based on improved PLD technique for deposition inorganic-organic nanocomposite coatings by one step and in one technological cycle. The disclosed method allows the coating of large surfaces, a selective coating of the substrate at predetermined places, coating a substrate with multiple layers. The disclosed method avoids damaging the coating material. One of major shortcomings of this technique for deposition nanocomposite thin films is relatively low deposition rate, due to different mechanisms of interaction of the laser beam with the three dimensional segmented target, including inorganic and organic materials and expensive vacuum equipment. The other major disadvantage in the above-described method is the necessity of use of contact masks for formation of micron, sub-micron or nanostructured array, objects or devices on the already formed nanocomposite thin film with subsequent additional expensive technological steps and operations.

For the rapid prototyping and production of smart sensors, new metamaterials or devices with applications in biomedicine, pharmacy, energy and aerospace industry is necessary high speed synthesis of 2D and 3D nanocomposite areas and objects with high resolution for micron, sub-micron and nanodimensions and simultaneous synthesis of nanocomposite macro objects.
The described drawbacks of the above - described PVD methods for the preparation of nanocomposite thin films and coatings can be partially overcome by technologies so called Rapid manufacturing or prototyping or Digital fabrication. Commonly this technique involves adding material successively, in layers, to create a solid of a predefined shape and objects using CAD-CAM systems. The replacement of historical first pulverization technique with a material transfer by using a laser beam, allowing precise formation with high resolution of objects from different materials and with micron, sub-micron and nano-dimensions.
Laser transfer technologies are rapid prototyping techniques for deposition and controlled pattering from meso- micro- and nano- 2 dimensional (2D), 3- dimensional (3D) materials and receiving increasing attention in many industries. The existing laser rapid prototyping techniques used for transfer and pattering different materials such as metals, dielectrics, semiconductors, alloys, organics, polymers, biopolymers, living cells or small mechanical or electronics structures or components. Recently various laser-based fabrication techniques can be grouped in terms of the mechanism of interaction on laser with transferring material on: Laser machining, Selective laser sintering, micro-laser sintering, Stereo lithography, Two-photon polymerization, Laser Direct Write (LDW). The LDW techniques are simple, flexible and cost effectiveness and suitable for scaling up in industrial applications.

One of the most popular techniques of LDW is the so-called laser-induced forward transfer (LIFT). The donor system for basic LIFT setups consists usually of a single source material layer that has been separately pre-coated as a thin plane film on top of a laser-transparent carrier substrate, typically fused silica supports or polymer films, depending on the laser wavelength. LIFT is based on LDW process where generally, focused laser beam is moving about the target and transfer the vaporized or ablated material or article onto receiver substrate (US Pat. 3,745,586 (RCA CORP.) and (J. Bohandy, B. F. Kim and F. J. Adrian "Metal deposition from a supported metal film using an excimer laser", J. Appl. Phys. 1986, 60, 1538-9). LIFT is method for selective laser vaporization or ablation of materials from preliminary deposited thin film on transparent carrier substrate - target and forward transfer the material onto receiver substrate closely fixed to target. At the classical LIFT the laser beam, (usually ultra violet -UV lasers) vaporizes or ablate the entire thin film in the region of laser focus. The classical LIFT techniques also exhibit a number of limitations in relation to the temperature increasing induced at the impact point of the laser beam. The methods were developed for microelectronics and in particular to the formation of conductive metal objects with micron dimensions for electronic-circuit fabrication. Those Laser-based techniques have been used successfully to transfer inorganic dielectric and ceramics patterns and objects also. A common disadvantage of the classical LIFT method and of all the methods developed for these principles is the use of transparent carrier substrate - target. This transparent target restricts the type of laser source with respect to the generated wavelength that should have minimal absorption. LIFT techniques have been previously investigated and developed for transfer of polymers and complex organic materials with limited success. Generally, organic compounds are easily damaged by photochemical and thermochemical reactions. A number of improved direct write technologies for minimal chemical and functional decomposition on the transferring organic material are known.

The modifications of LIFT for forming complex organic materials or polymers are Matrix-assisted pulsed laser evaporation direct-write (MAPLE DW) (US. Pat. No. 6,177,151) and Resonant Infrared Red (RIR) MAPLE DW (WO 2008/008750 A2). These techniques used selectively absorbing light energy materials or specific selected photon for targeted transfer of materials or structures onto receiving substrate without damages and defragmentation especially for organics and biomaterials. The shortcoming of this techniques are using of selectively absorbing light energy solvents/materials or expensive Free Electron Laser (FEL). Other disadvantage of these techniques for forming hybrid nanocomposites patterns or objects are necessary the inorganic material, usually nanoparticles, to be added preliminary in transferred double layered material before LIFT process, which required additional technological steps and higher price of the final product.

Other relevant prior art related to LIFT technique which were developed to prevent transfer of delicate organic materials are: Biological Laser Printing (Bio LP) (US. Pat. 6,936,311 B2); Absorbing film-assisted LIFT (AFA LIFT) (B. Hopp et al., " Absorbing film assisted laser induced forward transfer of fungi (trihoderma conidia)", Appl. Phys. Letters, 96, 6, 3478-81, 2004); Dynamic Release Layer (DRL-LIFT) (W. A. Tolbert et al., J. of Imaging Science and Technology, 37,41, 1993); Laser Induced Thermal Imaging (LITI) (G. B. Blanchet et al., "Large area high resolution dry printing of conducting polymers of organic electronics", Appl. Phys. Lett., 82, 3, 463, 2003). All these techniques typically used transformation of the energy of laser beam in the thermo-mechanical or shock wave energy by utilizing of sacrificial or Dynamic release layer (DRL-LIFT) or Release layers. These additional thin films are opaque, usually metallic thin films or thick polymer films between the carrier and the donor-substrate. The function of these films are to protect the delicate donor material during transfer only. The use of additional sacrificial or DRL films decrease optical resolution of transferred objects and the transferred object is contaminated uncontrolled with residual DRL droplets, which are major disadvantages.
The recently developed Ballistic Laser-Assisted Solid Transfer (BLAST) (D. Banks et al., "Balistic laser-assisted solid transfer (blast) from a thin film precursot", Opt. Express, 16, 3249-54, 2008) technique and its modification Laser Induced Solid Etching - LISE (D. P. Banks et al., "Etching and forward transfer of fused silica in solid phase by fs laser induced solid etching (LISE)", Appl. Surf. Sci., 255, 20, 8343-51, 2009) for intact or solid material transfer does not require a DRL and the main idea is to use several subsequent pulses with low energy (usual femtosecond -fs laser) for transfer a donor material to receiver trough transparent support. The method is not designed for direct synthesis and transfer of nanocomposite patterns or objects, which is the main shortcoming.
The possibilities for realization of novel 2D and 3D nanophotonic components and metamaterials based on LIFT method are mentioned in A. I. Kuznetsov, R. Kiyan, and B. N. Chichkov, "Laser fabrication of 2D and 3D metal nanoparticle structures and arrays", Optics Express, Vol. 18, No. 20 ,2010 and Wei Ting Chen, Ming Lun Tseng, Chun Yen Liao, "Fabrication of three-dimensional plasmonic cavity by femtosecond laser-induced forward transfer", Optics Express, Vol. 21, No. 1,618-24, 2013. Metal or multilayer thin films from metal, metal oxides, inorganic semiconductors are preliminary deposited onto transparent donor substrate by thermal evaporation or magnetron sputtering techniques on the back side of transparent donor-target. Another glass substrate acting as the receiver is tightly contacted with the donor substrate. A fs-laser is used as light source in this techniques. Three-dimensional nanostructures are produced by transfer of molten metal nanodroplets from thin metals that by solidification formed nanostructures. The drawbacks of these techniques are impossibility for direct synthesis and transfer of hybrid nanocomposites patterns and objects or hybrid nanoparticles and nanostructures. In all above-described methods inorganic nanoparticles add further to advance in the transferred material for the synthesis of nanocomposites patterns or objects, which general represents disadvantages.
A very promising inorganic materials for hybrid nanocomposite patterns and objects are aluminium nanoparticles and magnesium nanoparticles. Aluminium nanoparticles are highly effective catalysts with enhanced thermal conductivity and show optical, plasmonic resonances across a much broader region (from deep blue up to 200nm in UV spectrum) of the spectrum than either gold or silver, and can used for solar energy transforming industrial scaled-up devices and for other large-area optical devices and materials that would be too expensive to produce with noble metals. The antimicrobial behaviour of aluminium and aluminium oxide nanoparticles have carried out extensive studies for the last years. Possible applications are as drug delivery system, also. Magnesium alloys are used for the manufacture of biocompatible and biodegradable medical implants and magnesium nanoparticles exhibit highly ionic properties with biocidal activity against bacteria and the spores. Magnesium nanoparticles are also promising material for hydrogen storage and optical devices.

The organic material-matrix can start from organic polymers to more complex organometallics, drugs, proteins and enzymes or a combination thereof. The complex organic materials which can be used as matrix for novel hybrid nanocomposite materials with many applications are natural or recombinant proteins. The recombinant silk protein Spidroin have unique thermo-mechanical properties as well as he is biocompatible and biodegradable. This complex organic material is commercially available and are recommended for the manufacture of silk fibroin-based drug delivery system, phototermal devices and metamaterials devices. The functional properties of silk-based materials (usually solution) are achieved by preliminary mixing in suitable dopants to functionalize the devices. For example, the used dopants are metals, metals nanoparticles, silica, dyes, polymers or drugs. An excellent review of the current state of art was presented from Hu Tao, David L. Kaplan and Fiorenzo G. Omenetto "Silk Materials - A Road to Sustainable High Technology", Adv. Mater. 2012, 24, 2824-2837.

Disadvantages of recently developed technologies for synthesis of nanocomposites, where the matrix is proteins are prior addition of the inorganic component, multistage process for the preparation of nanocomposite object or patterns, such patterns techniques have also thermal limitation, the use of spray technique which have limitation regarding morphology of transferred objects and particular in homogeneity and uniformity, the use of mask which limits the resolution of formed objects and in general multistage process for the preparation of nanocomposite object or patterns.

In patent application US 2013/0310908 A1, metal nanoparticles are add to silk fibroin matrix for realization of photothermal device of superior features. The plasmonic nanoparticle-doped silk fibroin-based materials can be used as an implantable and biodegradable heating element activated by light. In this patent application, silk fibroin solution is prepared and is mixed with metal nanoparticles mechanically. The plasmonic nanoparticles can be additionally distributed in a pattern such as an optical pattern, a micropattern, or a nanopattern by known techniques, such as nanoprinting or etching.

In US patent 8,530,625 B2, a silk fibroin solution is combined with a therapeutic agent to form silk-fibroin article. The silk fibroin article may be a thread, fibre, film, foam, mesh, hydrogel, three-dimensional scaffold, tablet filling material, tablet coating, or microsphere.

In patent WO 2011/130335 A2, the silk materials is used as matrices for electronic components. The functional properties of these electronic components is achieved by additional deposition of a conductive material usually metal layer or thin film on the organic substrate by classical thermal evaporation or other PVD techniques. The patterns or objects are fabricated by means of lithography techniques or contact transfer technique, which represent disadvantages.

In US patent 6,025,110 is disclosed a method for generation of a three-dimensional object according to a stored, digital representation through layer-by-layer transfer of material onto a receiver, each layer corresponding to a layer of the three-dimensional representation. This method requires the presence of at least three layers, namely an ejection layer deposited between transfer layer and a carrier layer (transparent sheet). The ejection layer comprises a radiation-absorptive compound, which may be a pigment, a dye or a combination thereof, that absorb transfer radiation and in response thereto produces burst of gas, which causes ejection of the transfer layer. The necessary presence of an additional metal layer, which absorbs a part of laser energy, is to help for non-destructive transfer of polymeric layer. In many patents and literature for Laser Direct Transfer and Writing this additional layer is used under different names such as "dynamic release layer (DRL)", "light-to-heat conversion layer (usual metallic)", or "sacrificial layer". Further, the method according to US patent 6,025,110 suggests further layers, which are metal and metal oxide layers. Such layers absorb and ablate in response to, for example, infrared laser radiation are additional layers especially for exact infrared laser radiation (Nd: YAG laser with wavelenght 1064 nm) that only help for non-destructive polymeric transfer layer. The method disclosed in US patent 6,025,110 does not generate hybrid nanocomposite materials or nanostructures, instead it builds a three-dimensional object by laser ablation layer by layer. This method needs complex construction with at least three layers, a mask and/or a pattern. Due to the complex construction and ablation process, it cannot deposit or write precisely on the receiving substrate. In addition, only droplets of about 60 microns are deposited on the receiving substrate. Finally, in order to combine the polymeric and metal deposition to obtain an hybrid deposition, the method of US patent 6,025,110 uses two different tapes, the first tape containing a metal transfer layer and the second tape containing a polymer transfer layer, which makes the method more complex.
None of the aforementioned prior art that has intended use in the optical, biomedical and electronic industries describes a method or a process capable of fabricating of direct synthesis and printing of nanocomposite including hybrid nanocomposite patterns or object of new special optical, electronic, magnetic or other similar physical and chemical properties, which make such objects suitable for applications in above described industries.
For the above reasons, there is a need of an improved one step and one technological cycle method for rapid preparation of nanocomposite materials or nanostructures that does not suffer from the limitations of the prior art, that allows the possibility of direct depositing and/or writing nanocomposite materials or nanostructures on determined micro- and nano- areas on receiving substrates, that allows creating microarrays of nanocomposite materials on receiving substrates, and/or that allows generating products or materials with superior and new properties by one step and one technological cycle.

### SUMMARY OF THE INVENTION

The present invention provides a method for laser assisted synthesis according to claim 1. In one aspect, the present disclosure provides a method for laser assisted synthesis and/or formation of nanocomposite materials and contactless direct deposit and/or writing thereof onto a surface of a receiving substrate, comprising the steps of
- providing one or more sources of laser energy for producing laser energy;
- providing a focusing lens;
- providing a receiving substrate, wherein the receiving substrate is positioned opposite to the source of laser energy;
- providing a laser beam opaque inorganic target, wherein the laser beam opaque inorganic target is positioned between the receiving substrate and the source of the laser energy and wherein the laser beam opaque inorganic target comprises an organic layer that is deposited on the back side of the laser beam opaque inorganic target facing the receiving substrate, said organic layer being of a material having distinct physical and/or chemical properties from the laser beam opaque inorganic target material;
- providing a support for holding said laser beam opaque inorganic target at a fixed distance relative to said receiving substrate;
- positioning the laser beam opaque inorganic target comprising the organic layer in a spaced relation to the one or more sources of laser energy so that the laser energy from said one or more sources of laser energy is directed through the focusing lens to strike the laser beam opaque inorganic target comprising the organic layer at the defined target location to perforate the laser beam opaque inorganic target at said target location and create a projection of molten droplets of inorganic material; wherein said projection passes through the organic layer and said molten inorganic droplets ablate the organic material, thereby forming a projection of hybrid nanocomposite material containing inorganic material from the laser beam opaque inorganic target and organic material from the organic layer, wherein said projection of hybrid nanocomposite material is directed to the receiving substrate and said hybrid nanocomposite material is transferred and deposited at a defined location on the receiving substrate;
- repeating the steps of positioning and striking the laser beam opaque inorganic target at successive target location, thereby exposing the laser beam opaque inorganic target at said successive defined target location to the one or more sources of laser energy such that the deposit and/or writing of the hybrid nanocomposite material occurs at successive defined target locations of the receiving substrate.

In a further aspect, the present disclosure provides a use of the method of the invention for direct depositing and/or writing of hybrid nanocomposite material on a substrate.

In another aspect, the present disclosure also provides a device comprising a substrate with hybrid nanocomposite material deposited and/or written by the method according to the present disclosure.

### BRIEF DESCRIPTION OF THE FIGURES

Figure 1 shows a schematic representation of an apparatus used to perform the method of an embodiment of the present disclosure.
Figure 2 shows a lateral view of an exemplary segmented laser- opaque target coated on its back side with different organic materials and support.
Figure 3 shows a schematic representation (cross section) of a target showing the distribution of the laser energy in the plane of the focused laser beam.
Figure 4 shows optical and fluorescent micrographs of a transferred Al/Rhodamine 6G nanocomposite material as spots.
Figure 5 shows a fluorescence micrograph of a large-scale array and pattern/line of transferred Al/Rhodamine 6G nanocomposite material.
Figure 6 shows an optical and fluorescent micrographs of an transferred/fabricated/printed nanocomposite material at exceeded/overdose of laser energy with conical forms of arrays.
Figure 7 shows Scanning Electron Microscopy (SEM) micrographs on transferred nanocomposite arrays - A1 nanoparticles/Rh6G.

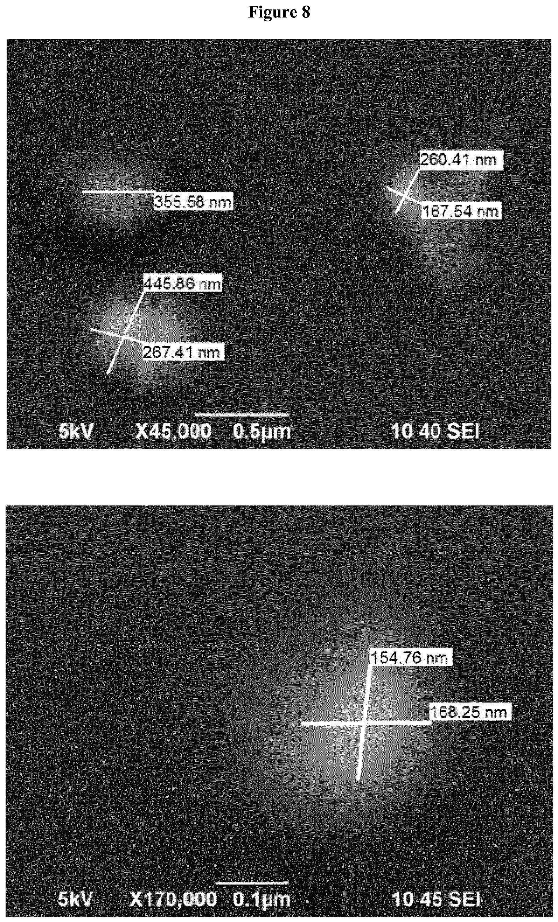

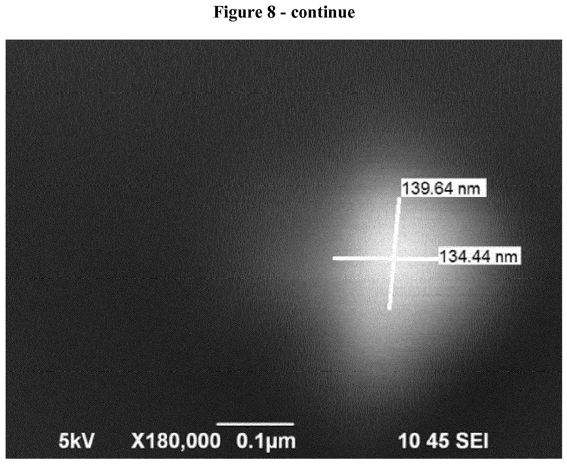

Figure 8 shows Scanning Electron Microscopy (SEM) micrographs on metal A1 nanoparticles in the matrix of transferred organic material -Rh6G.

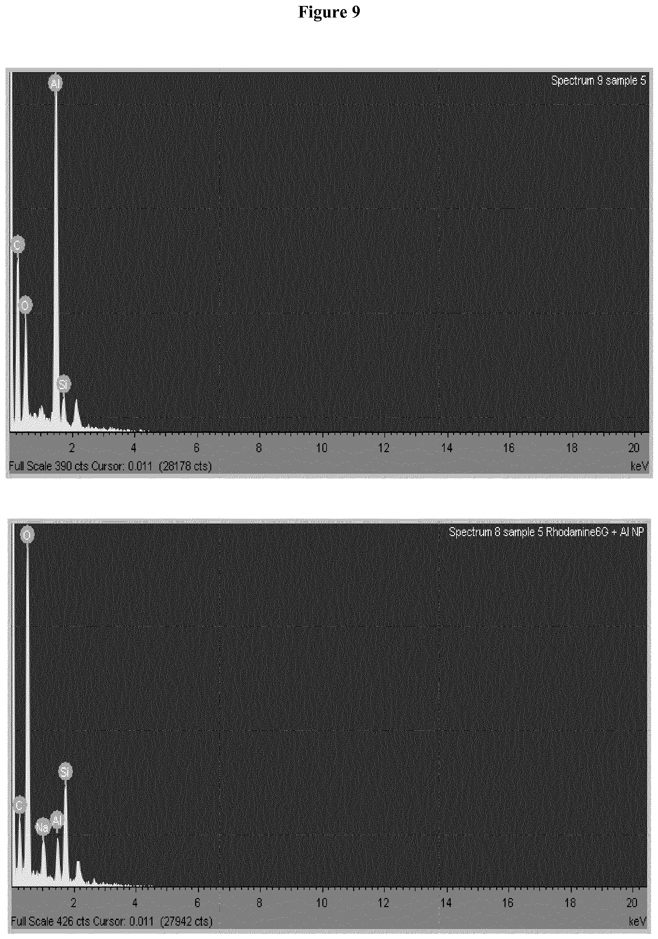

Figure 9 shows exemplary representation of the results of Energy-Dispersive X-ray spectroscopy (EDX) of the formed A1 nanoparticles and printing nanocomposite from Al/Rh6G in A1 nanoparticles and nanocomposite arrays.
Figure 10 shows Scanning Electron Microscopy (SEM) micrographs on hybrid nanoparticles with A1 metal core and organic Rh6G shelf (coating).
Figure 11 shows a fluorescent micrograph and Scanning Electron Microscopy (SEM) micrographs on transferred nanocomposite arrays - Mg nanoparticles/Spidroin.
Figure 12 shows a Scanning Electron Microscopy (SEM) micrographs on metal Mg nanoparticles in the matrix of transferred bioactive material - Spidroin.

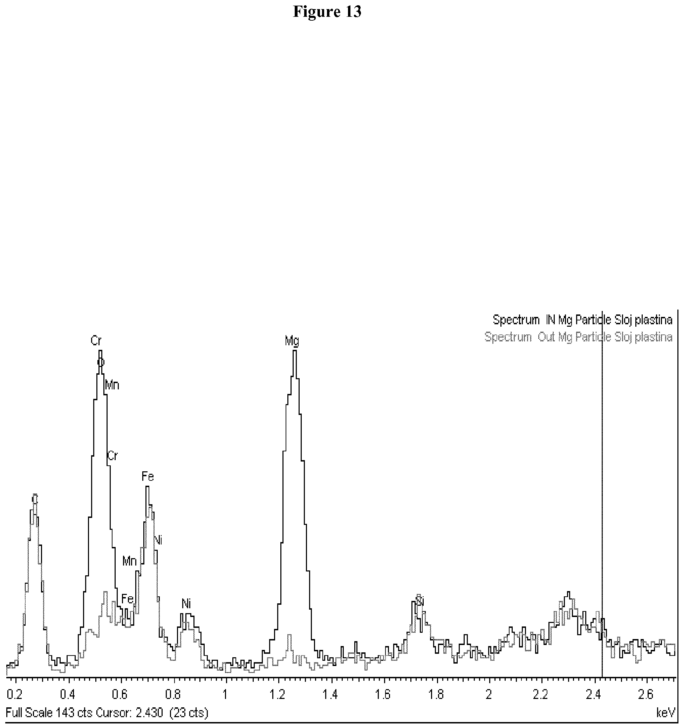

Figure 13 shows exemplary representation of the results of Energy-Dispersive X-ray spectroscopy (EDX) of the formed Mg nanoparticles and printing nanocomposite from Mg/Spidroin in Mg nanoparticles and nanocomposite arrays.

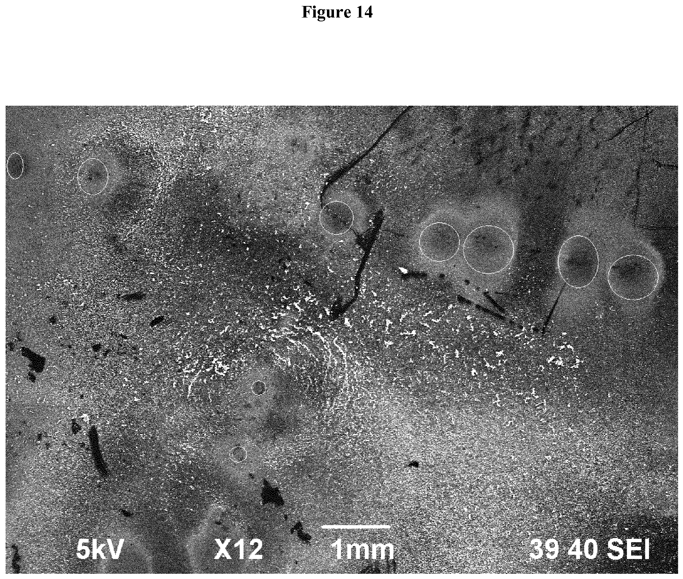

Figure 14 shows panoramic Scanning Electron Microscopy (SEM) micrograph on transferred nanocomposite arrays - A1 nanoparticles/Rh6G.
Figure 15 shows the photograph of produced hybrid nanocomposite tube with macro dimensions.
Figure 16 shows optical fluorescent microscopy of produced hybrid nanocomposite tube (a-filter DAPI x4, b- filter Texas Red x4; c- filter FITC x40 ; d - filter FITC x200 ; e- x4 optical microscopy).
Figure 17 shows the content of Paclitaxel in produced hybrid nanocomposite tube.
Figure 18 shows the chromatogram of Paclitaxel (tR=9.80) in the hybrid nanocomposite material-tube.

### DETAILED DESCRIPTION OF THE INVENTION

Although methods and materials similar or equivalent to those described herein can be used in the practice or testing of the present invention, suitable methods and materials are described below. All publications, patent applications, patents, and other references mentioned herein are incorporated by reference in their entirety. The publications and applications discussed herein are provided solely for their disclosure prior to the filing date of the present application. Nothing herein is to be construed as an admission that the present invention is not entitled to antedate such publication by virtue of prior invention. In addition, the materials, methods, and examples are illustrative only and are not intended to be limiting.

In the case of conflict, the present specification, including definitions, will control. Unless defined otherwise, all technical and scientific terms used herein have the same meaning as is commonly understood by one of skill in art to which the subject matter herein belongs. As used herein, the following definitions are supplied in order to facilitate the understanding of the present invention.

As used herein, the term "comprise" is generally used in the sense of include, that is to say permitting the presence of one or more features or components.

As used herein, the singular form "a", "an" and "the" include plural references unless the context clearly dictates otherwise.

As used in the specification and claims, the language "comprising" can include analogous embodiments described in terms of "consisting of" and/or "consisting essentially of'.

As used in the specification and claims, the term "and/or" used in a phrase such as "A and/or B" herein is intended to include "A and B", "A or B", "A", and "B".

As used herein, the terms "thin layer" and "thin film" in material combinations are used to describe layers with thicknesses ranging from a few nanometers to several micrometers (for example from 1 nm to 1000 µm), which are applied / deposited to a carrier material/device, hereinafter referred to as target and/or receiving substrate.

The term "direct write" and "direct writing" refers generally to any technique for creating a pattern of deposited material directly on a receiving substrate.

As used herein, the terms "laser", "laser beam", "source of laser energy" are used interchangeably to refer to any device that creates a laser beam.

As used therein, "nanocomposite", "nanocomposite materials" and "nanostructures" designate materials or structures having nano dimensions of 1 nm to 1000 nm. In addition, in the context of the present invention, these terms designate a composition comprising at least two components (two phases): one inorganic phase (the core), which is for example a metal and one organic phase (the shell) which coats the inorganic core and which is for example an organic compound having physical and/or chemical properties different from the core. For example, herein referred hybrid nanocomposite material designate a composition comprising inorganic material (phase) and organic material (phase), i.e. materials whose physical and/or chemical properties are very different from each other.

It is well known that one of the main problems for direct synthesis of hybrid - inorganic/organic nanocomposite materials by laser-based methods, such as LIFT methods, are the different energetic requirements for interaction between laser beam and organic or inorganic substance for transferring and writing the material onto substrate without damages of their functionality. In contrast with above-described conventional methods where the donor material is deposited on transparent support and wherein is used selectively absorbing light energy materials or specific selected photon for targeted transfer, or additional sacrificial or dynamic release layers, or several subsequent pulses with low energy for protection of complex organic material during transfer from damaging of organic material functionality, the method of the invention uses a laser beam opaque inorganic target (support) and an organic material layer coated on back side of said a laser beam opaque inorganic target (support) facing the receiving substrate.

The present invention provides a method for laser assisted synthesis and/or formation of nanocomposite materials and contactless direct deposit and/or writing thereof onto a surface of a receiving substrate, comprising the steps of
- providing one or more sources of laser energy for producing laser energy;
- providing a focusing lens;
- providing a receiving substrate, wherein the receiving substrate is positioned opposite to the source of laser energy;
- providing a laser beam opaque inorganic target, wherein the laser beam opaque inorganic target is positioned between the receiving substrate and the source of the laser energy and wherein the laser beam opaque inorganic target comprises an organic layer that is deposited on the back side of the laser beam opaque inorganic target facing the receiving substrate, said organic layer being of a material having distinct physical and/or chemical properties from the laser beam opaque inorganic target material;
- providing a support for holding said laser beam opaque inorganic target at a fixed distance relative to said receiving substrate;
- positioning the laser beam opaque inorganic target comprising the organic layer in a spaced relation to the one or more sources of laser energy so that the laser energy from said one or more sources of laser energy is directed through the focusing lens to strike the laser beam opaque inorganic target comprising the organic layer at the defined target location to perforate the laser beam opaque inorganic target at said target location and create a projection of molten droplets of inorganic material; wherein said projection passes through the organic layer and said molten inorganic droplets ablate the organic material, thereby forming a projection of hybrid nanocomposite material containing inorganic material from the laser beam opaque inorganic target and organic material from the organic layer, wherein said projection of hybrid nanocomposite material is directed to the receiving substrate and said hybrid nanocomposite material is transferred and deposited at a defined location on the receiving substrate;
- repeating the steps of positioning and striking the laser beam opaque inorganic target at successive target location, thereby exposing the laser beam opaque inorganic target at said successive defined target location to the one or more sources of laser energy such that the deposit and/or writing of the hybrid nanocomposite material occurs at successive defined target locations of the receiving substrate.

In an embodiment, the method of the invention is controlled by a computer.
In further embodiments, the method of the invention is carried out at ambient conditions or at vacuum conditions.
In another embodiment, the source of laser energy is a pulsed laser.
In certain embodiment, the receiving substrate comprises a non-planar surface.

In further embodiments, the laser beam opaque inorganic target is of any inorganic material selected from the group comprising metals, metal alloys, metal oxides, dielectrics, semiconductors, carbon. In some embodiments metals are selected from the group comprising alkaline earth metals (such as magnesium and calcium), alkali metals (such as sodium and potassium), elements of group 13 (XIII) of the Periodic Table of Elements (such as aluminium), transition metals of groups 3, 4, 5, 6, 7, 8, 9, 10, 11 and 12 of the Periodic Table of Elements (such as iron, cobalt, nickel, copper, zinc, silver, rhodium, gold, platinum, tungsten, titanium).

In another embodiments, the receiving substrate is made of one or more materials selected from the group comprising chemically functionalized glass, polymer-coated glass, quartz, natural hydrogel, synthetic hydrogel, uncoated glass, nitrocellulose coated glass, silicon, glass, plastics, metals, polymers, semiconductors and ceramics.

In further embodiments, the organic layer comprises one or more organic or bioactive materials selected from the group comprising organic chemical compounds, pharmaceutical drugs, organic polymers, dyes, peptides, proteins, recombinant proteins, DNA, portions of DNA strands, RNA, microorganisms, mammalian cells, stem cells, a layer of stained or fixed tissue, a layer of living tissue, and functional supporting media such as nutrients and other life supporting material. In preferred embodiments, the organic layer comprises a pharmaceutical drug or drugs.

In certain embodiments, the organic layer comprises suspended cells in a solution (medium). The cells are for example mammalian cells, which are in preferred embodiments selected from the group comprising dermal, fibroblasts, myoblasts, neural stem cells, endothelial cells, and cancer cells. The method of the invention allows high precision deposition and/or writing of individual cells or cells in relatively small 3D structures or stacks.

The method of the invention allows direct synthesis and writing of nanocomposite materials to provide structures and/or patterns in one step and in one technological cycle. The nanocomposites materials are made from materials whose physical and/or chemical properties are very different (hybrid nanocomposite materials). The disclosed method thus provides the structures and/or patterns consisting of hybrid nanocomposite materials or different nanocomposite materials including gradient nanocomposite structures, and having macro-, micro-, sub-micro- and nano- 2D and/or 3D forms and with different shapes, a selective patterns on different substrates at predetermined places. Arrangement of these micron sized (2D or 3D) structures with different physical/chemical properties along their surfaces can easily form large surface with recurrent (cyclic) properties, repeated the physical/chemical properties of a single micron sized nanocomposite structure.

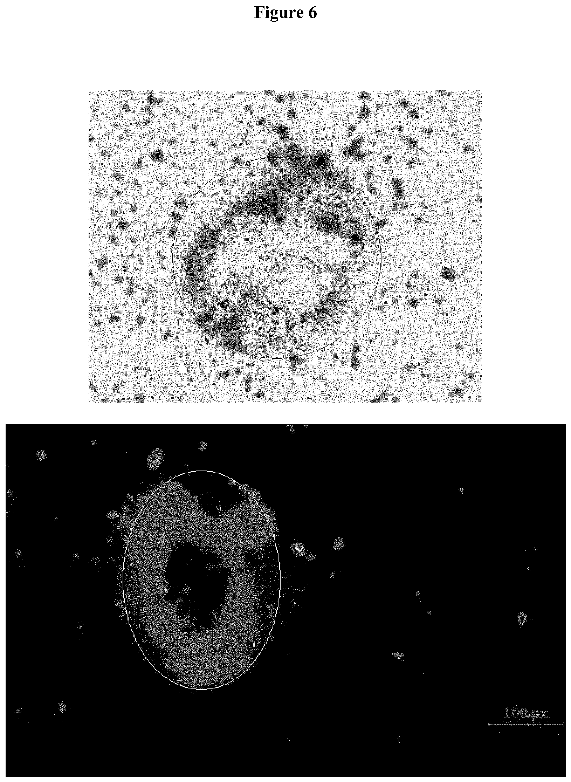

The method of the invention also allows direct synthesis and writing of double conical micro-sized structures or patterns consisting of hybrid nanomaterials (see Figure 6). The conical micro-structures show a different functionality compared to thin films from the same material, such as new porous functions and optical properties. The disclosed method in contrast with the prior art methods allows direct synthesis and writing of hybrid nanocomposites structures built from multifunctional materials - core-shell nanoparticles (i.e. inorganic core coated by organic shell) with strong control of dimensions, form and distribution. Due to the unique configuration, the core-shell nanostructured particles play increasing role in biomedical applications as biomedical imaging therapeutics, drug and gene delivery, purification of proteins, etc. The disclosed method allows direct synthesis and writing of large quantities of these multifunctional nanoparticles, which is difficult for the current state of the art chemical approaches.

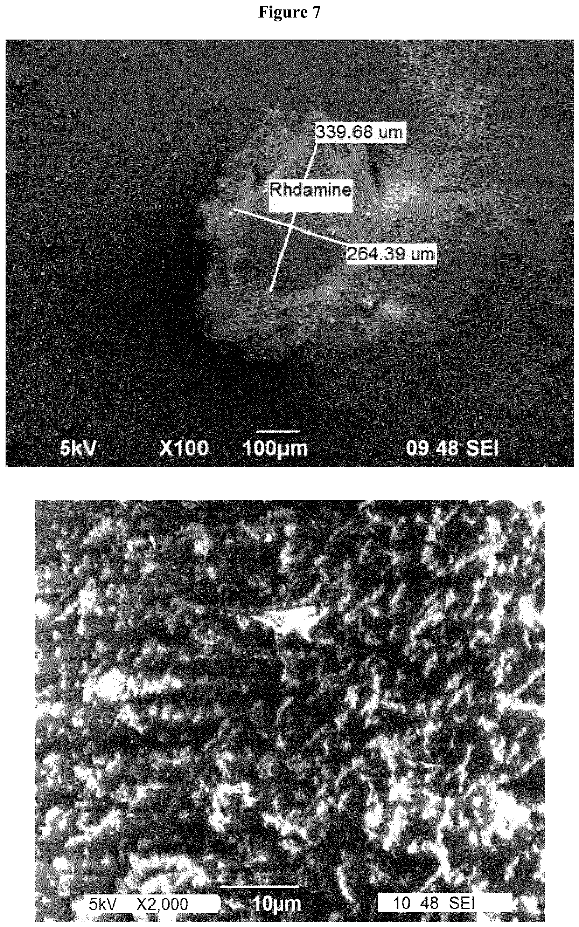

One of advantages of the method of the invention is that deposition and writing of hybrid nanocomposite materials on receiving substrate does not provide homogenous thin-films but inhomogeneous structures or patterns. For example, according to the invention, 2D and/or 3D micro- or submicro structures, patterns or arrays are provided, wherein the structure, pattern or array material properties become inhomogeneous depending on the thickness only (Z-direction, see Figure 7). As a result, typically (see Example 1) micron sized hybrid nanocomposite (2D or 3D) structures (see Figure 7) have different and new physical/chemical properties along their surfaces. Arrangement of these micron sized hybrid nanocomposite (2D or 3D) structures with different physical/chemical properties along their surfaces can easily form large surface with recurrent (cyclic) properties, repeating the physical/chemical properties of a single micron sized hybrid nanocomposite structure. In this relation, is disclosed herein (see Example 2) synthesis of double conical micron sized hybrid nanocomposite structures (see Figure 6). These conical nanocomposite structures have a different optical properties (usually higher refractive index) compared with thin films from the same material. These conical nanocomposite structures (Figure 6) can be determined as hybrid nanocomposite structure with new porous functions and new optical properties comparing to the thin-films provided by laser-based methods of the prior art. These new functions and properties are for example relating to the following:
1) by changing the amount of metal nanoparticles in the core of the nanocomposite structure, it is possible to control and modulate the electrical properties of conical structures, thereby providing a nanocomposite structure with controlled porosity. For example with presence of electrical charge, it is possible to control the porosity of the nanocomposite structure for specific objects (molecules for example or controlled ion channels) as desired.
2) by changing the dimensions of metal nanoparticles in the core of the nanocomposite structure, it is possible to control and modulate light reflection index by plasmon/polariton effects , i.e. molecular sensors.
3) refractive index can be controlled and modulated by changing the amount of metal nanoparticles or materials of nanoparticles only for defined structure. Thus, some parts of writing area can have structures with positive refractive index and some parts with negative refractive index.
The size-dependent properties include optical, catalytic, magnetic, surface reactivity, melting and specific heat, oxidative stability and other important properties. The organic shell (coating) of the hybrid nanocomposite materials of the present disclosure can be easily functionalized with other organic molecules interfaces for targeted applications. With a suitable and simple choice of core (inorganic phase) and shell (organic phase) materials, the hybrid nanocomposite structures may play a different, pre-determined role: active shell and passive core, active core and passive shell, active shell and active core i.e. controllable catalytic functions. Due to this unique configuration, the core-shell hybrid nanocomposite materials play increasing role in biomedical applications as biomedical imaging, therapeutics, drug and gene delivery, purification of proteins, etc. The method of the invention allows preparation of large quantities of these multifunctional nanoparticles which is difficult for the current state of the art chemical approaches.

In addition, the method of invention avoids damaging the components (phases) of the transferred material (such as organic material) as well as the receiving material of the receiving substrate. Specifically many organic materials, such as organic polymers, peptides or cells, are fragile, thermally labile, and can be irreversibly damaged by direct exposure to the laser energy. This is avoided in the method of the invention by placing the organic material on the back side of the laser beam opaque inorganic target, i.e. on the side opposite that of the impact of the laser energy (laser beam) on the laser beam opaque inorganic target.

It is well known that nanoparticles can be produced by laser ablation technique and that uniform metal nanoparticles are synthesized by laser ablation of thin metal layer. This technique prevents splashing of large nanoparticles and minimal nanoparticles agglomeration. It is also known that the energy distribution within a focused laser beam is non-uniform and density of the laser energy in axial direction can vary by several orders of magnitude and this variation is not linear.

The method of the invention takes advantage of the laser ablation technique and uses the non-uniform intensity (non-uniform energy distribution) over the cross-section of the focused laser beam for direct transfer of organic or more complex materials, such as biological active materials, depositing in one step and one technological cycle hybrid nanocomposite materials (or complex nanostructures) on determined micro- and nano- areas on receiving substrates, creating microarrays of hybrid nanocomposite materials on receiving substrates, and/or generating products or materials consisting of hybrid nanocomposite materials with superior and new properties.

The material of the laser beam opaque inorganic target may be any inorganic material, such as metals, metal alloys, metal oxides, dielectrics, semiconductors. In an embodiment, the thickness of the laser beam opaque inorganic target is in range of 1 µm to 300 µm.

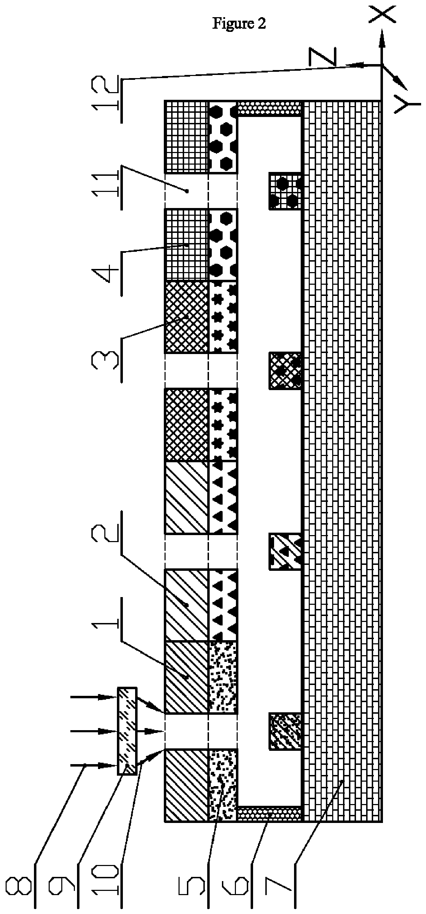

According to certain embodiments, the laser beam opaque inorganic target may be segmented into several segment, for example at least two, three or four segments (see Figure 2). Segments may be regions and/or planes. The form of segments has no restriction. The segments may comprise materials of same or different physical and/or chemical properties in each segment. It may for example comprise a first segment comprising a metal material, a second segment comprising a ceramic material, and a third segment comprising a semiconductor material. The segments may be located in a single plane or their thickness may be different.

According to another embodiments, the back side of the laser beam opaque inorganic target (i.e. the side facing the receiving substrate) is coated with organic materials that may be different for different segments if the laser beam opaque inorganic target is segmented into several segments (see Figure 2). The organic or biological active materials are coated on the back side of the laser beam opaque inorganic target prior to performing the method of the present invention. Multilayer compatible organic structures can be formed on the back side of the laser beam opaque inorganic target (or onto segments).

For the deposition (coating) of an organic thin layer (thin film) on the laser beam opaque inorganic target, organic materials/compounds are applied to said inorganic target by various methods of thin-film technology known in the art, such as spin coating, spray coatings, dip coating, polymerization, sputtering or others. The thickness of the organic thin layer (thin film) is usually similar to the thickness of the laser beam opaque inorganic target, but has no restrictions, as the thickness of the organic thin layer may be bigger in comparison of the thickness of the laser beam opaque inorganic target. In an embodiment, the thickness of the organic thin layer is in range 1 µm to 300 µm or it can be also less than 1µm.

Alternatively, an organic thin layer (thin film) can be previously prepared and contacted with the back side of the laser beam opaque inorganic target.

According to embodiments of the invention, the laser beam opaque inorganic target can contain more than one organic layer, such as two, three, four, five or more organic layers on the back side of the laser beam opaque inorganic target. This provides more complex hybrid nanocomposite materials, wherein the organic phase (part) contains several different organic compounds / materials. For examples such complex hybrid nanocomposite material can consists of magnesium phase (core) coated with organic phase (shell) consisting of organic polymers and proteins.

According to further embodiments of the invention, the laser beam opaque inorganic target can contain at least one additional inorganic layer (thin layer), such as two, three, four, five additional inorganic layers, on the back side, on the front side or both sides of the laser beam opaque inorganic target. The at least one additional inorganic layer comprises an electronic material selected from the group comprising metal, dielectric, resist, semiconductor, and combinations thereof; and wherein one or more electronic materials are used to create electronic circuitry on the receiving substrate. This provides more complex hybrid nanocomposite materials, wherein the inorganic phase (part) contains several different inorganic compounds / materials. For examples such complex hybrid nanocomposite material can consists of inorganic phase (core) consisting of magnesium, aluminium and ceramic materials coated with organic phase.

According to further embodiments of the present invention, the laser beam opaque inorganic target can contain at least one organic layer (thin layer), preferably two, three, four organic layers on the back side of the laser beam opaque inorganic target and at least one inorganic layer (thin layer), preferably two, three four inorganic layers, placed on the back side and/or, front side of the laser beam opaque inorganic target. This provides more complex hybrid nanocomposite materials, wherein the inorganic phase (part) contains several different inorganic compounds / materials and the organic phase (part) contains several different organic compounds / materials. For examples such complex hybrid nanocomposite material can consists of inorganic phase (core) consisting of magnesium, aluminium and ceramic materials coated with organic phase (shell) consisting of organic polymers and proteins.

The receiving substrate is a substrate and/or a surface that can be any solid material, planar or non-planar, onto which the hybride nanocomposite material is deposited according to the method of the invention. The receiving substrate can be part of and/or a surface of a device, such as a medical device, an electronic device, an optical device or an electro-mechanical device, or any multi-functional device. The receiving substrate is made of one or more materials selected from the group comprising chemically functionalized glass, polymer-coated glass, quartz, natural hydrogel, synthetic hydrogel, uncoated glass, nitrocellulose coated glass, silicon, glass, plastics, metals, and ceramics. The receiving substrate can comprise functionalization that interacts with the deposited hybride nanocomposite material. The functionalization is selected from the group comprising covalent functionalization, physisorbed functionalization, and combinations thereof. Surfaces with functionalization can be prepared by any method known in the art. Surfaces with functionalization can also occur naturally, such as a living host. Covalent functionalization is when the deposited hybrid nanocomposite material becomes covalently bonded to the surface of the receiving substrate. Physisorbed functionalization is when the deposited hybrid nanocomposite material becomes attached or adsorbed to the receiving substrate by means other than covalent bonding. Examples of functionalization include a living host, a living cell, a living cell culture, a non-living cell, a non-living group of cells, a living tissue, a chemically functionalized surface, and a biologically functionalized surface.

Any suitable laser source may be used in the present invention. In general, a pulsed laser is preferred with very short pulse in ns, ps or fs pulse duration. The short and ultra-short laser pulse prevent damage and defragmentation of organic or bioactive material deposited on the back side of laser beam opaque inorganic target. The short laser pulse prevent formation of liquid phase/melting at interaction with the laser beam opaque inorganic target. The pulsed lasers are commercially available within the spectral range from UV to IR. Examples of suitable lasers include, but are not limited to, pulsed gas lasers such as excimer lasers, i.e. F2 (157 nm), ArF (193 nm), KrF (248 nm). XeCl (308 nm), XeF(351 nm), pulsed solid state and fiber lasers such as Nd:YAG (1,06 µm), Ti:Sapphire (about 780 nm), Yb+, Er+ ,Ruby, diode pumped lasers, semiconductor lasers, CO2, N2(337,1 nm), metal vapor, etc. and pulsed dye laser systems. Typically, the particular laser is selected with regard to the energy needed to ablate material from laser beam opaque inorganic target without or very small melting phase, to create hole with minimal heat affected zone (HAZ) and with minimal dimensions and to interact with organic material of the back side of the laser beam opaque inorganic target without damage or defragmentation. The energy density should be high enough to create hole (or perforation) in the laser beam opaque inorganic target but not so high that the laser energy damages the transfer of organic material. When the laser beam opaque inorganic target has high reflection regarding wave length of laser beam and the organic material on back side is an active biomaterial, a typical range of energy density is about 5 mJ/cm² to about 700 mJ/cm². Higher energy densities are also possible. The particular laser is selected depending on beam profile, divergence of beam and point stability. Preferred selected lasers are with rotationally symmetrical Gaussian beam and M2 - beam propagation factor near to 1. The energy distribution within a focused laser beam is non-uniform and density of the laser energy in axial direction can vary by several orders of magnitude and this variation is not linear. The method of the invention uses this property as the area with biggest laser energy is fixed on the surface of the laser beam opaque inorganic target. The focusing lens is preferably selected that the length -"waist" of focused laser beam corresponds to the thickness of the laser beam opaque inorganic target and decreasing of laser energy in conjunct with thickness of organic material on the back side. The laser energy, i.e. the tightly focused laser beam is directed onto surface of the laser beam opaque inorganic target so that it strikes the laser beam opaque inorganic target. A part of the laser energy is reflected, another part is absorbed by the laser beam opaque inorganic target. A density of laser energy is selected so that it is mainly absorbed by the laser beam opaque inorganic target. The absorbed laser energy is transformed into energy that ablates / ejects material (i.e. atoms and/or molecules) from laser beam opaque inorganic target providing a drill hole, i.e. the laser energy perforates the laser beam opaque inorganic target. The ablation process forms a projection of material (atoms and molecules) which is directed to the receiving substrate through the organic layer. The projection passing through the organic layer on the back side of the laser beam opaque inorganic target is low energy, contains small molten inorganic droplets of inorganic material from the laser beam opaque inorganic target (said droplets can have micro- and/or nano-scale dimensions) and its energy decreases by interaction with the organic material. These small molten inorganic droplets of interact with the organic material from the back side of the laser beam opaque inorganic target and transmit their energy to said organic material. The energy of defocused laser beam and the energy of small molten inorganic droplets are enough for selective separation (ablation) of the organic material. In the space (gap) between the laser beam opaque inorganic target having the organic layer on the back side and the receiving substrate, thermalization and formation of new nanocomposite materials or nanostructures occurs, which contain material from the laser beam opaque target and organic material from the organic layer on the back side of the laser beam opaque target, thereby providing new nanocomposite materials of new and advantageous properties. The obtained nanocomposite materials or nanostructures can be deposited at defined receiving location on the receiving substrate. Said location can be for example either micro- or nano- area on the receiving substrate or a microarray of organic material. The space (gap) between laser beam opaque inorganic target with the organic layer on the back side and the receiving substrate should be enough so that new nanocomposite material or nanostructure have time for forming and enough energy for adhering to the receiving substrate. Thus usually the space (gap) between the laser beam opaque inorganic target and the receiving substrate is substantially bigger from the thickness of the laser beam opaque inorganic target with the organic layer on the back side. In some embodiments, the receiving substrate is positioned at about 5 µm to 800 µm distance from the surface of the organic layer on the back side of the laser beam opaque target.

The form and the material of the support holding the laser beam opaque inorganic target in a fixed distance relative to the receiving substrate can be of any type, but it must fix the laser beam opaque inorganic target and the receiving substrate at a determined distance from each other. Said distance can be different in different embodiments of the invention and is for example determined on the basis of the material of the laser beam opaque inorganic target, the organic material of the organic layer, the nature of the receiving substrate and/or the power of the laser energy and can thus be adapted to one or more of these parameters, for example by adapting the support and/or by choosing an support with adapted dimensions. Optionally the support can also fix the laser bean opaque inorganic target in stationary position relative to the receiving substrate, so that the laser bean opaque inorganic target is moved together with the receiving substrate during deposition of the hybrid nanocomposite material.

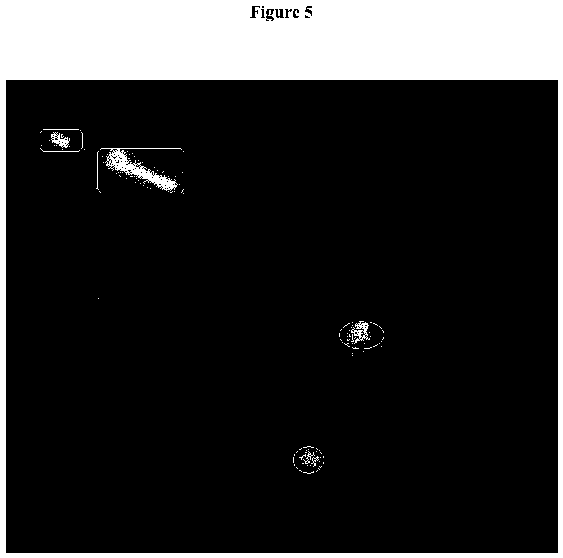

In the case when the energy of laser beam is bigger, not uniform or the biggest laser energy (the waist) is not fixed on the surface of the laser beam opaque inorganic target, conical nanocomposite structures can be formed and transferred (see Figure 5).

The dimensions of the laser energy can be controlled by any means known in the art so that only a precisely defined area of the laser beam opaque inorganic target is exposed to the laser energy and so that only a precisely defined portion of the material is ablated. The laser energy can be focussed through an objective to narrow the beam and ablate a portion of the laser beam opaque inorganic target material. It is possible to focus the laser energy so that it is small enough to transfer a single cell to the receiving substrate from the organic layer containing a cluster of cells. Single cell transfers can also be achieved by using a very dilute concentration of cells in the organic layer.

In some embodiments, the method of the present invention is carried out at ambient conditions. The ambient conditions are such as at about room temperature and at about atmospheric pressure. The method can also be carried out under one or more controlled conditions, such as humidity, pressure, vacuum, temperature, atmospheric composition, air pressure, and/or sterility. Controlled conditions may also include use of inert gases (such as helium, argon, neon, krypton, xenon or nitrogen), oxygen, alcohols, hydrocarbons and/or combination thereof (for example helium/argon).

Positioning the laser beam opaque inorganic target and/or the receiving substrate, and/or positioning the source of laser energy, in order to strike the inorganic target at a defined (determined) position (location) is achieved through the use of one or more positioning means. These positioning means can be any positioning means known in the art for supporting the source of laser energy and/or the laser beam opaque inorganic target, for example together with the receiving substrate, and moving them in a controlled and defined manner. For example, to deposit hybrid nanocomopsite materials on the receiving substrate and thereby create a pattern/line, structures or microarray of hybrid nanocomposites on the receiving substrate, the laser beam opaque inorganic target (having an organic layer), which is for example fixedly attached to the receiving substrate by supports, is placed on a CNC coordinate device and moved relative to the static source of laser energy (laser beam). The CNC coordinate device, preferably a CNC coordinate table, is connected to or comprises a controller device, for example a computer capable of carrying out an algorithm designed to automatically provide movements to said CNC coordinate device in desired directions, such as 2D directions or 3D directions. Of course, it is understood that both the CNC coordinate device and the controller device would be connected to a power supply. The movement velocity of the laser beam opaque inorganic target having an organic layer is for example from 10 µm/s to 1000 µm/s, preferably 500 µm/s. Alternatively, the source of laser energy and/or the laser beam can move relative to the laser beam opaque inorganic target (having an organic layer) and the receiving substrate, which are static in this case. The laser or the laser beam velocity can be for example from 10 µm/s to 1000 µm/s, preferably 500 µm/s. Commercially available, computer-controlled translation stages or galvanometric laser scanning devices may be used for rapid motion and high-resolution patterns from the individually synthesized and written 2D or 3D areas or arrays from transferred nanocomposite materials.

To increase the thickness of deposited hybrid nanocomposite material and/or to deposit several successive layers of different hybrid nanocomposite materials, in case when the laser beam opaque inorganic target for example comprises several segments containing different inorganic and/or organic material, at a particular defined receiving location on the receiving substrate, the source of the laser energy and/or the laser beam and the receiving substrate can be held stationary with respect to each other and the laser beam opaque target is moved with respect to the laser beam. The laser energy is thus directed to a new defined target location on the laser beam opaque inorganic target, having the organic layer, where the material has not yet been ablated. The hybrid nanocomposite material is deposited onto the same defined receiving location on the receiving substrate, thereby forming a deposit of increased thickness and/or different deposited hybrid nanocomposite material.

The positioning techniques described above can also be combined in order to deposit several successive structured layers of different hybrid nanocomposite materials on a single receiving substrate.

In contrast to many laser-induced forward transfer mechanisms (such as LIFT), the method of the invention does not use laser-transparent target substrate with source material film (i.e. material to be deposited / transferred) coated on the opposite side of the transparent target substrate and do not rely on the use of a plume of ablated material from the dynamic release layer (DRL) to transfer the material(s) or selectively absorbing light energy materials or specific selected photon energy. Indeed, typically in the prior art methods, the laser interacts with a source material film, which is typically coated onto a non-absorbing carrier substrate (laser-transparent target substrate). The incident laser beam propagates through the transparent carrier before the photons are absorbed by the back surface of the film.

Also in contrast to the known laser-based methods, the method of the invention does not provide homogenous thin-film deposition, but discrete and precise deposition of hybrid nanocomposite material that together provide inhomogeneous structures and/or patterns consisting of these hybrid nanocomposite materials or different nanocomposite materials including gradient nanocomposite structures, and having macro-, micro-, sub-micro- and nano-2D and/or 3D forms with different shapes at predetermined places on receiving substrate.

The known laser-based methods useful for thin-film deposition are for example pulsed laser deposition (PLD) or matrix-assisted pulsed laser evaporation (MAPLE), which have been developed to grow thin films of inorganic and organic materials. Both known methods are based on laser ablation of a target material under vacuum conditions. On the laser interaction, inorganic materials get vaporized to form a plasma, which transports the components via the gas phase toward a receiver substrate where the redeposition process takes place. Even when such laser-based deposition methods enable the growth of homogenous thin films, they have the disadvantage that only complete layers with no lateral resolution are formed, that it is difficult to control and manage precise special deposition (i.e. decide where and which nanocomposite material to deposit on the receiving substrate).

Also contrary to the known laser-based methods, the method of the invention does not use shadow masks. This allows to avoid all disadvantages of shadow masks, such as recondensation of most of the evaporated material on the shadow mask area itself, and therefore deposition of only a small part passing the stencil apertures on the receiver surface (substrate). Further, small openings in the mask (as, e.g., needed for the fabrication of arrays of small pixels for display screens) tend to become overgrown by the evaporated material, and have therefore to be cleaned frequently. Printing larger areas with such delicate masks proved also to be rather difficult because of shape distortions and their weak mechanical stability. In addition, the laser-based methods using shadow masks are essentially limited for low volatile compounds such as ionic compounds, ceramics, andpolymers.

In addition, due to the fact that the laser beam strikes directly the opaque inorganic target, the method of the invention does not rely on plume of ablated material and therefore provides great precision and better control for depositing hybrid nanocomposite materials and for defining the structure (microstructures, arrays) on selected substrate (receiving surface). This is opposite to the laser-based methods of the prior art which rely on plumes of ablated material to provide more uniform homogenous coating.

The method of the invention, in contrast to laser-based methods for deposition of thin nanocomposite films, allows controlled amount of hybrid nanocomposite materials in deposited structures, patterns or arrays; controlled form of hybrid nanocomposite materials in deposited structures, patterns or arrays; controlled distribution of hybrid nanocomposite materials in deposited structures, patterns or arrays; controlled size of hybrid nanocomposite materials in deposited structures, patterns or arrays; controlled amount of deposited structures, patterns or arrays on receiving substrate, controlled form of deposited structures, patterns or arrays on receiving substrate; and controlled size of deposited structures, patterns or arrays on receiving substrate.

The major advantages of the method of the invention are multifunctional role of the laser beam opaque inorganic target (support) and organic material coated on the back side thereof, such as (i) abolishment of limitation of used laser type in relation of laser wavelength; (ii) the major part of the energy of unwanted ablation process, which causes destruction and damage by thermo- and photo- reaction of organics material is directed in opposite direction of the delicate organic material (i.e. it is reflected, not absorbed); (iii) the laser beam opaque inorganic target (support) serve as generator of inorganic nanoparticles, thus only part of laser energy interacts with the organic material coated on the back side, these generated nanoparticles interact with organic material to provide novel hybrid nanocomposite material to be transferred on the receiving substrate as intact material.

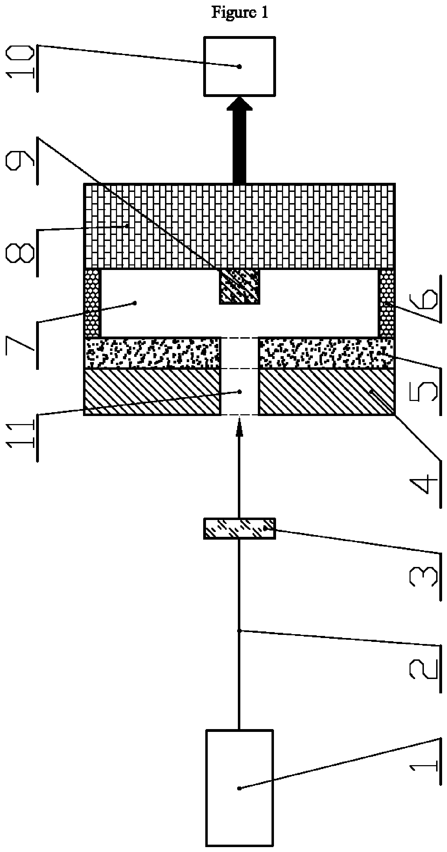

Figures 1 to 3 show schematic representation of arrangements for performing the method of the present invention. The illustrated embodiments are purely illustrative and in no way limiting. In particular, the arrangement can be varied, for example to adapt different components to various applications and/or to manufacturing constraints, material limitations, etc.

Figure 1 shows a schematic representation of an arrangement for performing the method according to an embodiment of the present invention for direct deposition of nanocomposites and nanostructures. The method uses a laser source **1** that produce laser energy (i.e. laser beam) **2,** focusing lens **3,** laser beam opaque inorganic target **4,** organic layer of organic or bioactive material **5,** which is placed in contact on the back side of the laser beam opaque inorganic target **4,** support **6** which forms a space (gap) **7** between the laser beam opaque inorganic target **4** coated on the back side with organic layer **5,** receiving substrate **8,** transferred nanocomposite material or nanostructure **9,** CNC coordinate table **10.** The laser beam opaque inorganic target **4** and organic layer **5** placed in contact on the back side of the laser beam opaque inorganic target **4** can be planar or non planar. The laser beam opaque inorganic target **4** can be any solid material as metals, alloys, ceramics, semiconductors, carbon. The organic or bioactive material **5** can be any organic materials such as drugs, organic polymers, dyes, peptides, proteins, recombinant proteins, or biomaterial in its active or living state. An active biomaterial is one that is capable of performing its natural or intended biological function. Suitable biomaterials can comprise any of the following examples, but are not limited to these examples: recombinant proteins as Spidroin, DNA, portions of DNA strands, RNA, protein, microorganisms, mammalian cells, stem cells, a layer of stained or fixed tissue, a layer of living tissue, and functional supporting media such as nutrients and other life supporting material.

The receiving substrate **8** can be planar or non planar. The receiving substrate **8** may be of any solid material such as metals, polymers, carbon, glass, chemically functionalized glass, polymer coated glass, quartz, natural hydrogel, synthetic hydrogel, uncoated glass, nitrocellulose coated glass, plastics, semiconductors and ceramics.

The source of laser energy **1** is positioned in a spaced relation to the laser beam opaque inorganic target **4,** so that the laser energy, i.e. the laser beam **2** will strike the laser beam opaque inorganic target **4** with organic layer of organic or bioactive material **5,** which is placed in contact on back side of the laser beam opaque inorganic target **4** at a defined target location and with defined density of laser energy. The laser energy **2** is sufficient energy to cause hole **11** (or perforation) in the laser beam opaque inorganic target **4** having a layer of organic or bioactive material.

The laser **1** (Figure 1), the laser beam opaque inorganic target **4,** and the receiving substrate **8** should be moveable with respect to each other so that the nanocomposite material **9** can be deposited in a microarray and so that after the nanocomposite material **9** ablated (ejected, separated) from one defined target location on the laser beam opaque inorganic target **4,** the laser beam **2** can be directed to another defined target location on the laser beam opaque inorganic target **4** where the nanocomposite material **9** has not yet been ablated (ejected, separated). For example, according to an embodiment of the present invention, to deposit a line of nanocomposite material **9** on the receiving substrate **8,** the laser beam **2** is moved with respect to the laser beam opaque inorganic target substrate **4** and the receiving substrate **8,** which may be held stationary with respect to each other. As the laser beam **2** moves, the laser beam **2** is directed to a new defined target location on the laser beam opaque inorganic target substrate **4,** where the nanocomposite material **9** has not yet been ablated, and causes the nanocomposite material **9** to be deposited onto a new defined receiving location on the receiving substrate **8.** The successive defined receiving location may overlap to the extent necessary to create a continuous line of deposited nanocomposite material **9** on the receiving substrate **8.**
To increase the thickness of deposited nanocomposite material or to form 3D nanostructure **9** (Figure 1) at a particular defined receiving location, the laser beam **2** and the receiving substrate **8** are held stationary (static) with respect to each other and the laser beam opaque inorganic target **4** is moved with respect to the laser beam **2** and the receiving substrate **8.** The laser beam **2** is directed to a new defined target location on the laser beam opaque inorganic target **4** where the nanocomposite material **9** has not yet been ablated (ejected, separated) and transferred. The nanocomposite material **9** is deposited onto the same defined receiving location on the receiving substrate **8** in an increasingly thickened deposit or forms 3D nanostructure. The movements can be also in rotational planes.
Figure 2 shows a lateral view of an exemplary segmented laser beam opaque inorganic target coated on back side with different organic materials according to an embodiment of the present disclosure. The segmented laser beam opaque inorganic target coated on back side with different organic materials comprises, for example metal laser beam opaque inorganic target **1** coated on back side with an organic material **5,** dielectric laser beam opaque inorganic target **2** coated on back side with an organic material **5,** semiconductor laser beam opaque inorganic target **3** coated on back side with an organic material **5,** ceramic laser beam opaque inorganic target **4** coated on back side with an bioactive material **5.** The segmented laser beam opaque inorganic targets **1, 2, 3, 4** coated on the back side with different organic and/or bioactive materials are placed in nests with holes on holder (not shown). The holder is fixed on support **6,** which forms a gap 7 between the laser beam opaque inorganic targets **1, 2, 3, 4,** having on the back side organic or bioactive materials, and the receiving substrate **7.** The distance between segmented and coated laser beam opaque inorganic targets and the receiving substrate **7** is equal for all segmented laser beam opaque inorganic targets **1, 2, 3, 4.** The thickness of segmented laser beam opaque inorganic targets **1, 2, 3, 4** may to be different. The source of laser energy **8** is positioned in a spaced relation to the laser beam opaque inorganic targets **1, 2, 3, 4,** so that the laser energy, i.e. laser beam **10** will strike through the focusing lens **9** the laser beam opaque inorganic targets **1, 2, 3, 4** having organic or bioactive materials placed in contact on back side of the laser beam opaque inorganic target **4** at a defined target location and with defined density of laser energy. Each individual segment **1, 2, 3,** and **4** can be of any desired shape, for example, circular, rectangular, elliptical or any other complex shape. The laser energy. i..e the laser beam **10** is sufficient energy to cause holes **11** in the laser beam opaque inorganic targets **1, 2, 3, 4.** The defined targets **1, 2, 3, 4** location with defined density of laser energy are achieved by using CNC 3 axis coordinate table **12** or scanning device, which adjust the place of the laser beam opaque inorganic targets **1, 2, 3, 4** in 3 axis. The density of the laser energy, i.e. the laser beam **10** can be controlled by any means known in the art so that only a precisely defined area of the targets **1, 2, 3, 4** is exposed to the laser energy. In some embodiments, the method is controlled by a computer. It is possible to use several laser sources for the each segment of segmented laser beam opaque inorganic target coated of back side with different organic materials.

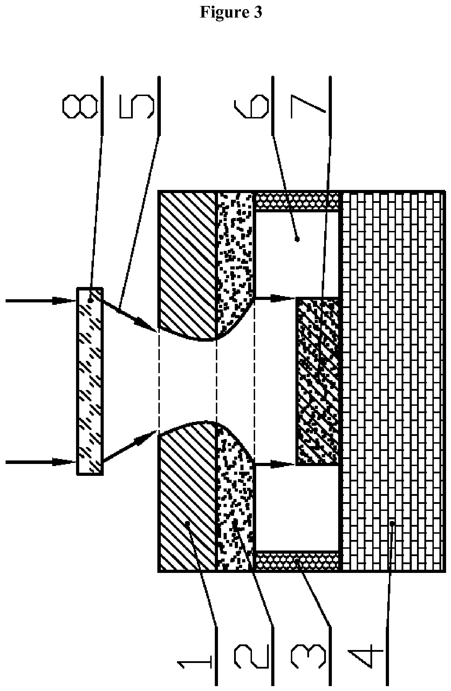

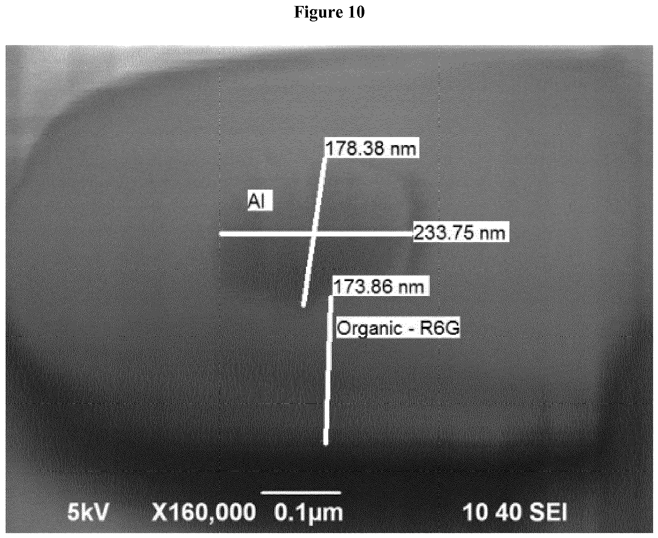

Figure 3 is a schematic representation (cross section) of an arrangement for performing the method according to an embodiment of the present invention showing distribution of the laser energy in the plane of the laser energy - focused laser beam **5** (focusing lens **8**). The laser beam opaque inorganic target **1** is typically planar. The composition/material of the laser beam opaque inorganic target **1** is selected in accordance with the particular nanoparticles or nanostructures that must be synthesized and in accordance to the used laser source. On the back side of the laser beam opaque inorganic target **1** is placed organic material in form of layer (thin layer) **2** with direct contact with the laser beam opaque inorganic target **1.** The formation of organic layer can be realized with any existing techniques for deposition of organic layers such as spin coating, spray coatings, dip coating, polymerization or others. The thickness of organic layer (thin layer) **2** is similar to the thickness of the laser beam opaque inorganic target **1** but has no restrictions as the thickness of organic layer may be dick in comparison of the thickness of the laser beam opaque inorganic target **1.** In some embodiments, the thickness of the laser beam opaque inorganic target **1** and the organic layer **2** are in range 1 µm to 300 µm. The support **3** serves for forming the space (gap) **6** between the laser beam opaque inorganic target **1** with the organic layer **2** on back side and the receiving substrate **4.** The form and the material of the support **3** can be of any type, but must fix the laser beam opaque inorganic target **1** with organic layer **2** and the receiving substrate **4** at fixed distance relative to one another. The space (gap) **6** between the laser beam opaque inorganic target **1** with organic layer **2** and the receiving substrate **4** is determined by the support. According to another embodiment of the present invention, the method of the invention can be used to synthesise (prepare) hybrid nanocompositions or hybride nanocomposite material (see Figure 10) consisting of a metal core or other inorganic nanoparticle core coated with organic compounds. These nanocompositions are obtained by simply replacing the receiving substrate by a container, which collects said nanocompositons. The container should be placed at a distance (for example from 1mm to 1cm) sufficient to allow the energy of nancompositions to lower in order to avoid that the nanocompositions adhere on the surface of the container. The hybrid nanocompositions have different properties than inorganic components and organic compounds alone. This includes but is not limited to the properties such as thermal, optical, dielectric, strength, electrical conductivity and/or combination thereof. For example, polymer nancompositions having metal cores have different electrical, chemical, mechanical and/or physical properties than polymer nanocompositions alone.
The method of the invention can be used for direct depositing and/or writing hybrid nanocomposite material on a substrate. In preferred embodiments, the substrate is part of a medical device, an electronic device, an optical device or an electro-mechanical device.

In another aspect, the present disclosure provides a device comprising a substrate with hybrid nanocomposite material deposited by the method according to the invention. In preferred embodiments, the device is a medical device, an electronic device, an optical device or an electro-mechanical device.
The method of the invention can be used to provide coatings (in preferred embodiments nano- or micro- coatings) with medical applications and industrial applications, such as aerospace, automobile, nano-catalyst and electronic industries.

The method of the invention is used for coating a device. In preferred embodiments, the coating is nanocoating or microcoating. In some embodiments, a device is a medical device. In other embodiments, a device is an electronic device. In further embodiments, a device is an optical device. In other embodiments, a device is an electro-mechanical device.

Some examples of medical devices which may be coated in accordance with the present method include, but are not limited to, sutures, staples, meshes, patches, slings, stents, catheters, endotracheal tubes, grafts, clips, pins, screws, rivets, tacks, bone plates, drug delivery devices, drug-releasing implants, surgical instruments, drug eluting balloons, adhesives, sealants, wound dressings, woven devices, non-woven devices, braided devices, adhesion barriers, tissue scaffolds, and other implants. In certain embodiments, the medical device may be formed from one or more filaments. The filaments can be knitted, braided, woven or non-woven. In preferred embodiments, the medical device is selected from the group comprising stents, catheters, drug-releasing implants, surgical instruments or drug eluting balloons.

The medical device can be formed from any sterilizable material that has suitable physical properties for the intended use of the medical device. The medical device can be bioabsorbable or non-bioabsorbable. Some specific examples of suitable absorbable materials which may be utilized to form the medical device include trimethylene carbonate, caprolactone, dioxanone, glycolic acid, lactic acid, glycolide, lactide, homopolymers thereof, copolymers thereof, and combinations thereof. Some specific examples of suitable non-absorbable materials which may be utilized to form the medical device include polyolefins such as polyethylene, polypropylene, copolymers of polyethylene and polypropylene, and blends of polyethylene and polypropylene.

The hybrid nanocomposite structures or patterns obtained by the method of the invention are particularly suitable for medical devices and equipment such as implants, tissue engineering, chemoselective or bioselective sensors, devices in the pharmacy, metamaterials devices, flexible and organic electronics, the energy sector, in aeronautics and aerospace, and also the automotive industry. Examples of such devices are stents, catheters, drug-releasing implants, biosensors, surface acoustic wave devices (ASW), optical waveguides, optical devices, solar cells.

The method of the present invention can be particularly well used for coating medical devices with pharmaceutical drugs (medicinal products). In some embodiments, the medical devices are selected from the group comprising stents, catheters, drug-releasing implants, surgical instruments or drug eluting balloons. Nanostructured drug delivery system plays a key role to improve the time release of drug molecules and enable more precise drug targeting.
The method of the present invention can provide hybrid nanocomposite coatings of medical devices, with precise drug dose adjustment, which functions as programmed drug delivery device. Such precise drug dose coating is impossible with known laser-based method that deposit randomly thin-layers. The hybrid inorganic-organic nanocomposite coatings can contain inorganic nanoparticles, such as Mg, Fe, A1 or Ca and drug(s) or more complex organic materials, such as peptides or proteins.
The method of the invention is suitable for the fabrication of microdevices, where sensitive and functional materials have to be arranged in a controlled manner without degrading their desirable properties. For microdevice fabrication, not only the quality of transferred patterns with respect to local resolution, feature morphology, and homogeneity play an essential role but also, in particular, the conservation of desired functional properties of the deposited material systems.
The method of the invention is also suitable for the fabrication of chemosensors and biosensors, where biomaterials such as nucleic acids, proteins, enzymes, cells, and microorganisms have to be accurately deposited.
The method of the invention is further suitable for the fabrication of microarrays of biomolecules, which are interesting in the development of biosensors and play an important role as efficient tools for gene and protein identification.

The present disclosure is therefore to be considered as in all aspects illustrated and not restrictive, the scope of the invention being limited by the appended Claims, and all changes which come within the meaning and range of equivalency are intended to be embraced therein.
Various references are cited throughout this Specification, each of which is incorporated herein by reference in its entirety.
The foregoing description will be more fully understood with reference to the following Examples. Such Examples, are, however, exemplary of methods of practicing the present invention and are not intended to limit the scope of the invention.

### EXAMPLES

### Example 1

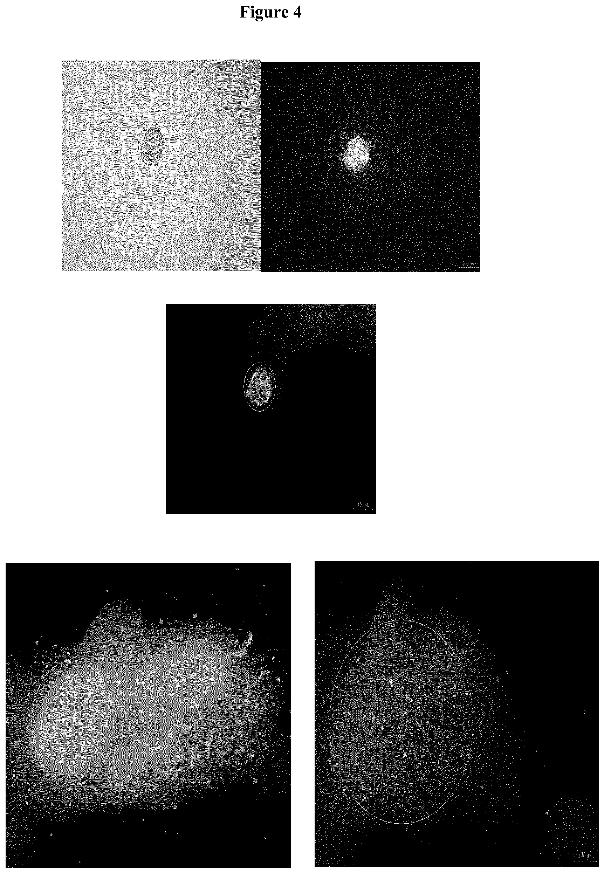

This example describes direct synthesize and writing of a micro-array of metallic-organic hybrid nanocomposite structure by one step and in one technological cycle. To create/synthesize of a micro-array of metallic-organic hybrid nanocomposite material in one step and in one technological cycle an aluminum (Al) laser beam opaque inorganic target (for example see Figure 3, laser beam opaque target **1**) was used with thickness 50 µm, purity 98% and area of 4 cm². On the back side of Al laser beam opaque inorganic target was deposited an organic layer of Rhodamine 6G (Rh6G), an organic fluorescent dye (Sigma Aldrich) by spin coating having a layer thickness of 7 µm (for example see Figure 3, organic layer **2**). The receiving substrate (for example see Figure 3, receiving substrate **4**) was glass slide with thickness 200 µm, area of 4 cm², previously cleaned in ultrasonic bad with acetone, ethanol and deionized water and dried with argon (Ar). The receiving substrate was positioned on 600 µm from the surface of organic layer Rhodamine 6G on back side of laser beam opaque inorganic target using four steel supports (for example see Figure 3, support **3**). The aluminum (Al) laser beam opaque inorganic target with deposited organic layer of Rhodamine 6G and glass receiving substrate positioned opposite to Al laser beam opaque target at 600 µm distance from the surface of the organic layer were fixed on CNC coordinate table. A TEA Nitrogen (N2) laser with a wavelength of 337.1 nm, a pulse duration of 4 ns and an energy per pulse of 0,8 mJ and a repetition rate of up to 100 Hz was directed by meniscus quartz lens at the surface of aluminum (Al) laser beam opaque inorganic target. The repetition rate of the laser pulse was 1Hz and the laser energy density ranged from 300 mJ/cm² to 500 mJ/ cm² onto surface of laser beam opaque inorganic Al target. To create a pattern/line from metallic-organic hybrid nanocomposite material in one step and in one technological cycle the aluminum (Al) laser beam opaque inorganic target with deposited organic layer of Rhodamine 6G and glass receiving substrate positioned opposite to inorganic laser beam opaque target at 600 µm distance from the surface of the organic layer were moved with velocity of 500 µm/s in respect to the focused laser beam by means of CNC coordinate table controlled by a computer. When laser energy density was more than 500 mJ/ cm² on the receiving substrate were created conical arrays from hybrid nanocomposite material. In a process with exceeded/overdose of laser energy part form ablated material was reached to already ready transferred hybrid nanocomposite material (see Figure 6). The dimensions of laser direct writing nanocomposite arrays were in range from 250 µm to 350 µm. The dimensions of metal (Al) nanoparticles in organic matrix (coating) were in range from 150 nm to 350 nm. The dimensions of hybrid nanoparticles with Al metal core and organic Rh6G shelf were in range: metal core about 200 nm and organic shelf about 250 nm. The process was carried out at ambient conditions. The viability of the transferred arrays and patterns/line were verified through optical/fluorescent detection (fluorescent microscopy) (see Figures 4 and 5). The nanocomposite arrays produced according to the above-mentioned method was examined by scanning electron microscopy (SEM) and energy dispersive x-ray (EDX) spectroscopy.

### Example 2

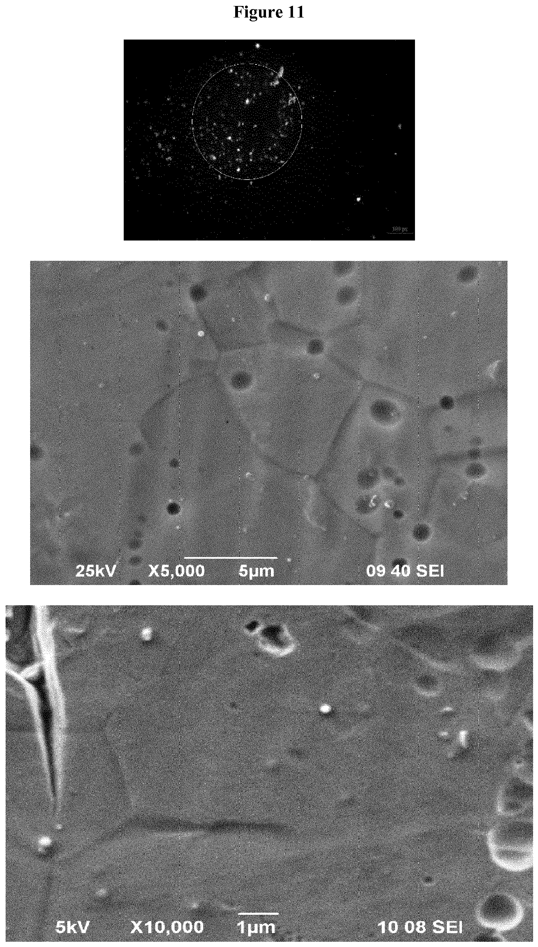

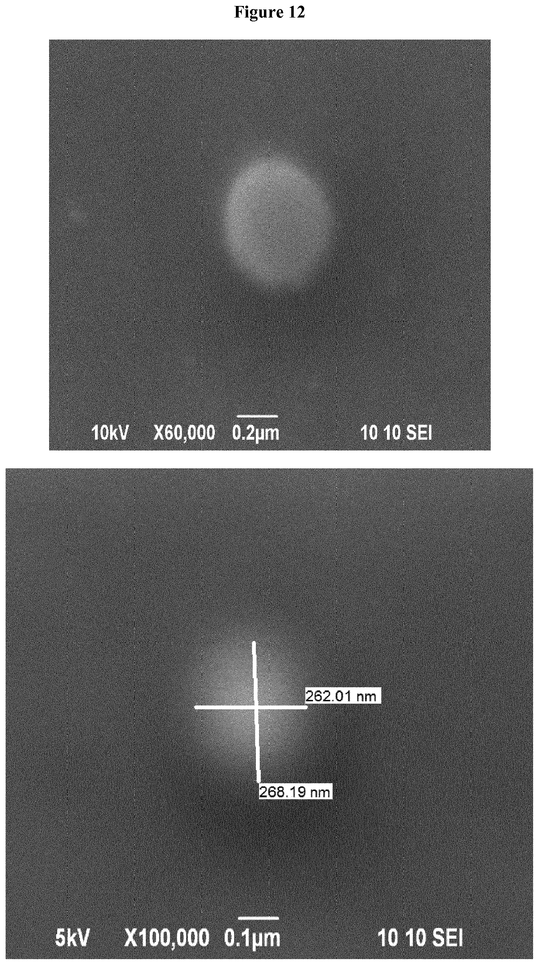

This example describes direct synthesis and writing of micro-array hybrid nanocomposites from active biomaterial Spidroin as matrix and magnesium (Mg) nanoparticles in the matrix by one step and in one technological cycle. The recombinant silk protein Spidroin have unique thermo-mechanical properties. Spidroin is biocompatible, biodegradable and promising material for biomedical and tissue engineering applications.
Micro-array nanocomposites material from active biomaterial Spidroin as matrix (coating) and magnesium (Mg) nanoparticles (core) in the matrix in one step and in one technological cycle were prepared. The magnesium (Mg) alloy laser beam opaque inorganic target was used with thickness of 45 µm, purity higher than 99, 5 % and area of 4 cm². The advantages of magnesium are biocompatibility, biodegradability, anticorrosion properties. On the back side of Mg alloy laser beam opaque inorganic target was deposited an organic layer of bioactive material - recombinant silk protein Spidroin (1409 amino acids, molecular weight/mass: 113859.5, atomic composition: Carbon (C) - 4780, Hydrogen (H) - 7180, Nitrogen (N) - 1640, Oxygen (O) - 1640, Sulfur (S) - 0, by spin coating having a layer thickness of 10 µm. Before deposition, the lyophilized Spidroin biopolymer was dissolved by standard procedure in 10% lithium chloride and 90% formic acid, dried and cleaned in ethanol. The recombinant silk protein Spidroin is biocompatible and biodegradable and has unique thermo-mechanical properties. The receiving substrate was stainless steel 316L plate with thickness 300 µm, area of 4 cm², previously cleaned in ultrasonic bad with acetone, ethanol and deionized water and dried with dry argon (Ar). The receiving substrate was positioned at 400 µm distance from the surface of the bioactive layer of Spidroin by using four steel supports. The magnesium alloy (Mg) laser beam opaque inorganic target with deposited biopolymer layer of Spidroin and stainless steel 316L receiving substrate positioned opposite to Mg laser beam opaque inorganic target at 400 µm distance from the surface of biopolymer layer were fixed on CNC coordinate table. A TEA N2 laser with a wavelength of 337,1 nm, a pulse duration of 4 ns and an energy per pulse of 0,5 mJ and a repetition rate of up to 100 Hz was directed by meniscus quartz lens at the surface of magnesium alloy (Mg) laser beam opaque inorganic target. The repetition rate of the laser pulse was 1Hz and the laser energy density ranged from 100 mJ/cm² to 300 mJ/ cm² onto surface of laser beam opaque inorganic Mg target. The dimensions of laser writing nanocomposite arrays were in range from 200 µm to 350 µm. The dimensions of metal (Mg alloy) nanoparticles in biopolymer matrix (coating) were in range from 200 nm to 260 nm. The viability of the transferred arrays and patterns were verified through optical/fluorescent detection (fluorescent microscopy) (see Figure 11). The nanocomposite arrays produced in this way was examined by scanning electron microscopy (SEM, see Figure 12) and energy dispersive x-ray (EDX) spectroscopy.

### Example 3

This example describe a printing of macro-object, hybrid nanocomposite tube with dimensions: outside diameter - 1300 microns; inside diameter - 800 microns; height - 3250 microns. The tube is composed from active biomaterial Spidroin and Paclitaxel as matrix and magnesium (Mg) nanoparticles in the matrix. Paclitaxel is used as an antiproliferative agent for the prevention of restenosis (recurrent narrowing). Paclitaxel is applied as a coating for medical implants - stents for targeted drug delivery. This drug is proven as a mitotic inhibitor used in cancer chemotherapy, also.

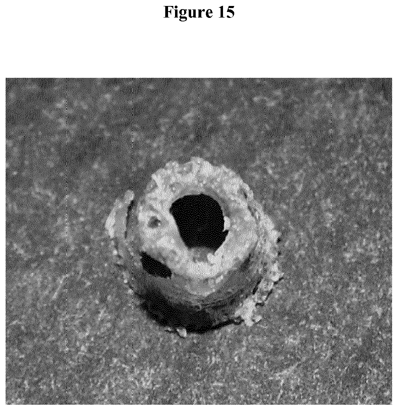

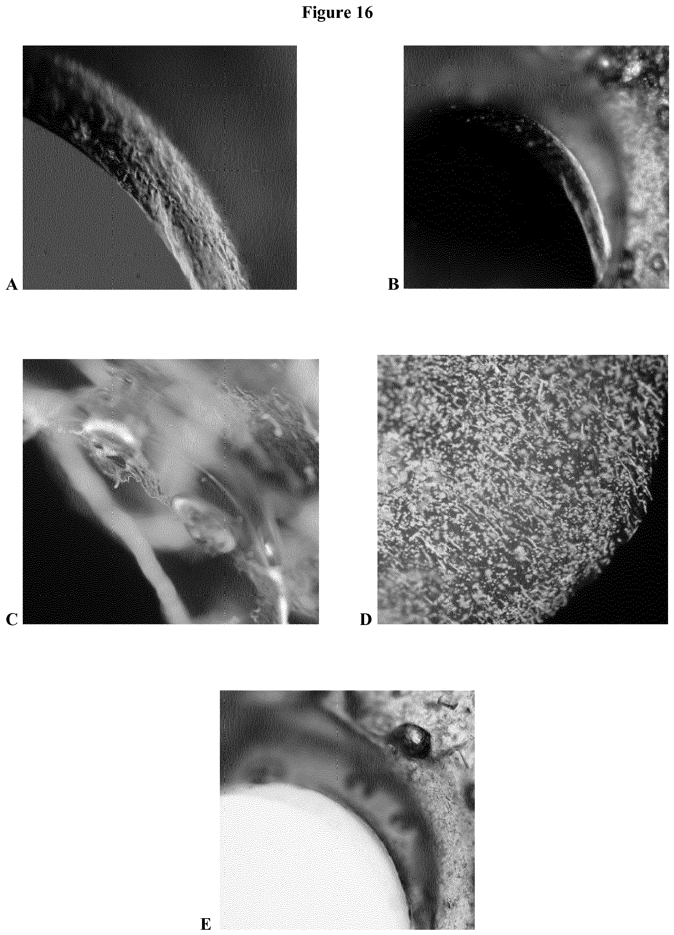

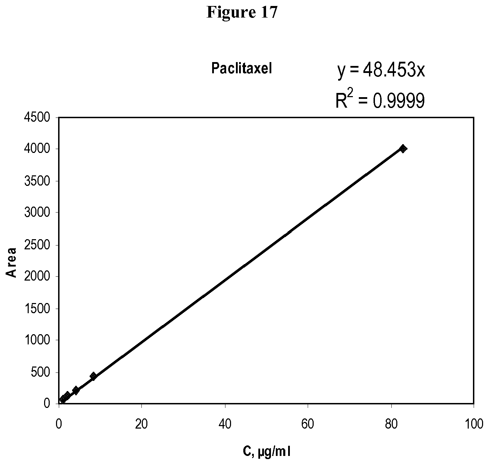

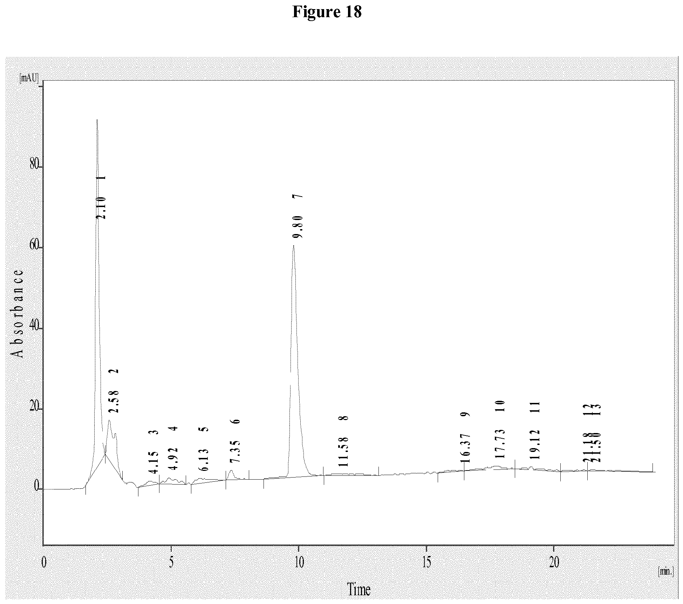

The magnesium (Mg) alloy opaque for laser beam inorganic target 1 (Fig2) was used with thickness 100 µm, purity bigger then 99, 5 % and area of 1 cm2. On the back side of Mg alloy opaque for laser beam inorganic target 1 was deposited of organic layer 2 from bioactive material - recombinant silk protein Spidroin with number of amino acids: 1409 , Molecular weight/mass: 113859.5, Atomic composition: Carbon (C) - 4780, Hydrogen (H) - 7180, Nitrogen (N) - 1640, Oxygen (O) - 1640, Sulfur (S) - 0 and Paclitaxel (Sigma Aldrich). After standard procedure for lyophilization of Spidrion, the biopolymer was dissolved by standard procedure in 10% lithium chloride and 90% formic acid, dried and cleaned in ethanol. The Paclitaxel was dissolved in chemical pure ethanol at concentration 50 mg/mL. The dried and cleaned biopolymer is added to a solution of Paclitaxel and after intensive mechanical mixing the mixture for Spidroin and Paclitaxel is deposited by spin coating having a layer thickness of 25 µm. The receiving substrate 4 was stainless steel 316L plate with thickness 500 µm, area of 1 cm2, preliminary cleaned in ultrasonic bad with acetone, ethanol and deionized water and dried with dry argon (Ar). The receiving substrate 4 was mechanically positioned and fixed on 700 µm from the surface of bioactive layer from Spidroin and Paclitaxel on back side 2 using four steel supports - 3. For the direct synthesis and printing of hybrid nanocomposite tube with height - 3250 microns were prepared 12 identical targets containing opaque for laser beam inorganic Mg target with deposited on the back side of Mg material organic layer from Spidroin and Paclitaxel. The device comprising magnesium alloy (Mg) opaque for laser beam inorganic target 1 with deposited biopolymer layer 2 from Spidroin and stainless steel 316L receiving substrate 4 positioned opposite inorganic target 1 on 400 µm from the surface of biopolymer layer 2 was fixed on CNC coordinate table. For each loading distance between the target consisting Mg material and organic layer from Spidroin and Paclitaxel and the receiving substrate 4 was kept at 400 µm. We note that this process can be automated through an additional device accurately transferring in x-y direction or only in one direction regarding receiving substrate 4 the target consisting Mg material and organic layer from Spidroin and Paclitaxel. A Nd;YLF laser with a wavelength of 532,7 nm, a pulse duration of 20 ns and an energy per pulse of 1 mJ was aimed by meniscus quartz lens at the surface of magnesium alloy (Mg) opaque for laser beam inorganic target 1. The repetition rate of the laser pulse was 1000 Hz and the laser energy density ranged from 0,12 mJ/cm2 to 0,35 mJ/ cm2 onto surface of inorganic Mg target 1. The height of laser writing single nanocomposite circuit layer/pattern was in range from 200 µm to 350 µm. The direct synthesis of the hybrid nanocomposite tube with dimensions: outside diameter - 1300 microns; inside diameter - 800 microns; height - 3250 microns was manufactured after 12 cycles of consecutive transferring of material from target to receiving substrate. The mechanical parts remaining in the middle of the produced hybrid nanocomposite tube were removed mechanically. Fig.15 shows the photograph of produced hybrid nanocomposite tube with macro dimensions. The viability of the produced hybrid nanocomposite tube were verified through optical/fluorescent detection (fluorescent microscopy) - Fig.16 (a- DAPI x4, b- Texas Red x4; c- FITC x40 ; d-FITC x200). Identification of Paclitaxel drug in hybrid nanocomposite object - tube was done by High-Performance Liquid Chromatographic (HPLC) method. The HPLC method shows a reliable and precise analysis of Paclitaxel drug. The list of chemicals, consumptions and equipment used in this investigation is given in Table 1. All chemicals used for HPLC analysis were of HPLC grade. Ammonium acetate was of analytical grade. Standard solution of Paclitaxel for HPLC analysis were prepared by using the same material from hybrid nanocomposite tube (3 samples) without further purification in concentration of 1mg/ml. Extraction of Paclitaxel were scraped out in 0.5ml acetonitril (AcN). The volume of every sample was measured before HPLC analysis. The instrumentation used for HPLC analysis consisted of quaternary mixer Smartline Manager 5000, pump Smartline 1000 and DAD 2800 detector (Knauer, Germany). Chromatography was carried out on Purospher Rstar RP-18e 25cm x 4.6mm i.d., 5µm particle size (Merck, Germany). The Paclitaxel mobile phase composition was prepared as follow: A - 50:50=AcN:H2O and B- 90:10= AcN:H2O. The elution of Paclitaxel substances followed the gradient profile: 0-20 min, 100%A to 0%A (100%B) and 20-25 min at 100%B. The samples were monitored at 278nm, 254nm and at 227nm, simultaneously. The limit of quantification (LOQ) of substance was by concentration of 1.0 µg/ml. Each sample was analyzed twice, and the mean value was used for calculation. The confirmation of the identity of the chromatographic peaks was achieved by comparison of retention times of samples with those of standard substance. The content of Paclitaxel was determined by the external method using the calibration curves established with five dilutions of Paclitaxel standard , with correlation coefficient between 0.999 (Figure 17). The chromatogram of Paclitaxel (tR=9.80) in the hybrid nanocomposite material -tube is shown on Figure 18 which coinciding with the chromatogram of the starting material.

**Table 1. List of chemicals, consumptions and equipment**

| Chemicals | Consumptions | Equipment |
|---|---|---|
| Water (double | Graduated glass pipettes with | Analytical balance (Kern, |
| distillated) | piston, 1.0ml 0.01ml and 2.0ml, 0.02 (Assistant, Germany) | d=0.1 mg) |
| Acetonitril (AcN) (Lab-Scan) | Vials for HPLC, from 1.7 ml to 5.0ml | HPLC apparatus (Knauer, Germany) |
| Trifluoroacetic acid (TFA) (Fluka) | Syringe for HPLC, 100µl (Hamilton) | Chromatographic column Purospher ^{R}star RP-18e 25cm x 4.6mm i.d., 5µm particle size (Merck, Germany) |
| Ammonium acetate (Fluka) | Volumetric flask, 100ml | |

## Claims

1. A method for laser assisted synthesis and/or formation of hybrid nanocomposite materials and contactless direct deposit and/or writing thereof onto a surface of a receiving substrate, comprising the steps of:
- providing one or more sources of laser energy for producing laser energy;
- providing a focusing lens;
- providing a receiving substrate, wherein the receiving substrate is positioned opposite to the source of laser energy;
- providing a laser beam opaque inorganic target, wherein the laser beam opaque inorganic target is positioned between the receiving substrate and the source of the laser energy and wherein the laser beam opaque inorganic target comprises an organic layer that is deposited on the back side of the laser beam opaque inorganic target facing the receiving substrate, said organic layer being in direct contact with said laser beam opaque inorganic target, and said organic layer being of a material having distinct physical and/or chemical properties from the laser beam opaque inorganic target material;
- providing a support for holding said laser beam opaque inorganic target at a fixed distance relative to said receiving substrate;
- positioning the laser beam opaque inorganic target comprising the organic layer in a spaced relation to the one or more sources of laser energy so that the laser energy from said one or more sources of laser energy is directed through the focusing lens to strike directly the laser beam opaque inorganic target comprising the organic layer at the defined target location to perforate the laser beam opaque inorganic target at said target location and create a projection of molten droplets of inorganic material; wherein said projection passes through the organic layer and said molten inorganic droplets ablate the organic material, thereby forming a projection of hybrid nanocomposite material containing inorganic material from the laser beam opaque inorganic target and organic material from the organic layer, wherein said projection of hybrid nanocomposite material is directed to the receiving substrate and said hybrid nanocomposite material is transferred and deposited at a defined location on the receiving substrate;
- repeating the steps of positioning and striking the laser beam opaque inorganic target at successive target location, thereby exposing the laser beam opaque inorganic target at said successive defined target location to the one or more sources of laser energy such that deposit and/or writing of the hybrid nanocomposite material occurs at successive defined target locations of the receiving substrate.

2. The method of claim 1, wherein the method is controlled by a computer.

3. The method of claims 1 or 2, wherein said method is carried out at ambient conditions or at vacuum conditions.

4. The method of any one of claims 1-3, wherein the source of laser energy is a pulsed laser.

5. The method of any one of claims 1-4, wherein the receiving substrate comprises a non-planar surface.

6. The method of claims 1-5, wherein the receiving substrate is made of one or more materials selected from the group comprising chemically functionalized glass, polymer-coated glass, quartz, natural hydrogel, synthetic hydrogel, uncoated glass, nitrocellulose coated glass, silicon, glass, plastics, metals, polymers, semiconductors and ceramics.

7. The method of any one of claims 1-6, wherein the laser beam opaque inorganic target is of any inorganic material selected from the group comprising metals, metal alloys, metal oxides, dielectrics, semiconductors.

8. The method of any one of claims 1-7, wherein the organic layer comprises one or more organic or bioactive materials selected from the group comprising chemical compounds, pharmaceutical drugs, organic polymers, dyes, peptides, proteins, recombinant proteins, DNA, portions of DNA strands, RNA, microorganisms, mammalian cells, stem cells, a layer of stained or fixed tissue, a layer of living tissue, and functional supporting media such as nutrients and other life supporting material.

9. The method of any one of claims 1-8, wherein the receiving substrate is part of a medical device, an electronic device, an optical device or an electro-mechanical device.

10. Use of the method of any one of claims 1-8 for direct depositing and/or writing of hybrid nanocomposite material on a substrate.

11. The use of claim 10, wherein the substrate is part of a medical device, an electronic device, an optical device or an electro-mechanical device.

## Patentansprüche

1. Verfahren zur laserunterstützten Synthese und/oder Bildung von Nanokompositmaterialien und deren kontaktlose direkte Abscheidung und/oder Schreibung auf einer Oberfläche eines aufnehmenden Substrats, mit den folgenden Schritten:
- Bereitstellen einer oder mehrerer Quellen von Laserenergie zur Erzeugung von Laserenergie;
- Bereitstellen einer Fokussierlinse;
- Bereitstellen eines Aufnahmesubstrats, wobei das Aufnahmesubstrat gegenüber der Laserenergiequelle angeordnet ist;
- Bereitstellen eines laserstrahldichten anorganischen Targets, wobei das laserstrahldichte anorganische Target zwischen dem Aufnahmesubstrat und der Laserenergiequelle angeordnet ist und worin das laserstrahldichte anorganische Target eine organische Schicht umfasst, welche auf der dem Empfangssubstrat zugewandten Rückseite des laserstrahldichten anorganischen Targets abgeschieden wird, wobei die besagte organische Schicht in direktem Kontakt mit dem besagten laserstrahldichten anorganischen Target steht, und wobei die besagte organische Schicht aus einem Material mit unterschiedlichen physikalischen und/oder chemischen Eigenschaften wie das laserstrahldichte anorganische Targetmaterial besteht;
- Bereitstellen einer Halterung zum Halten des laserstrahldichten anorganischen Targets in einem festen Abstand in Bezug auf das Empfangssubstrat;
- Positionieren des laserstrahldichten anorganischen Targets mit der organischen Schicht in einer beabstandeten Beziehung zu der einen oder den mehreren Laserenergiequellen, so dass die Laserenergie aus der besagten einen oder den besagten mehreren Laserenergiequellen durch die Fokussierlinse gerichtet wird, um das laserstrahldichte anorganische Target mit der organischen Schicht an der definierten Targetstelle direkt zu treffen, um das laserstrahldichte anorganische Target an der besagten Targetstelle zu perforieren und einen Strahl von geschmolzenen Tröpfchen aus anorganischem Material zu erzeugen; worin der besagte Strahl durch die organische Schicht hindurchgeht und die beesagten geschmolzenen anorganischen Tröpfchen das organische Material durch Ablation entfernen, wodurch ein Strahl von hybridem Nanokompositmaterial mit anorganischem Material aus dem laserstrahldichten anorganischen Target und dem organischen Material aus der organischen Schicht gebildet wird, worin der besagte Strahl von hybridem Nanokompositmaterial auf das Empfangssubstrat gerichtet wird und das besagte hybride Nanokompositmaterial an einer definierten Stelle auf dem Empfangssubstrat transferiert und abgeschieden wird;
- Wiederholen der Schritte des Positionierens und Treffens des laserstrahldichten anorganischen Targets an aufeinanderfolgenden Targetstellen, wodurch das laserstrahldichte anorganische Target an der besagten sukzessiven definierten Targetstelle der einen oder mehreren Laserenergiequellen freigelegt wird, so dass das Abscheiden und/oder Schreiben des hybriden Nanokompositmaterials sukzessive an aufeinanderfolgenden definierten Targetstellen des Empfangssubstrats erfolgt.

2. Verfahren gemäss Anspruch 1, worin das Verfahren von einem Computer gesteuert wird.

3. Verfahren gemäss Anspruch 1 oder 2, worin das Verfahren bei Umgebungsbedingungen oder unter Vakuumbedngungen durchgeführt wird.

4. Verfahren gemäss irgendeinem der Ansprüche 1-3, worin die Laserenergiequele ein gepulster Laser ist.

5. Verfahren gemäss iregend einem der Ansprüche 1 bis 4, worin das Empfangssubstrat eine nicht planare Oberfläche umfasst.

6. Verfahren gemäss den Ansprüchen 1 bis 5, worin das Empfangssubstrat aus einem oder mehreren Materialien hergestellt ist, ausgewählt aus der Gruppe umfassend chemisch funktionalisiertes Glas, polymerbeschichtetes Glas, Quarz, natürliches Hydrogel, synthetisches Hydrogel, unbeschichtetes Glas, nitrocellulosebeschichtetes Glas, Silizium, Glas, Kunststoffe, Metalle, Polymere, Halbleiter und Keramik.

7. Verfahren gemäss irgendeinem der Ansprüche 1 bis 6, worin das laserstrahldichte anorganische Target aus einem beliebigen anorganischen Material besteht, ausgewählt aus der Gruppe umfassend Metalle, Metalllegierungen, Metalloxide, Dielektrika, Halbleiter.

8. Verfahren gemäss irgendeinem der Ansprüche 1 bis 7, worin die organische Schicht ein oder mehrere organische oder bioaktive Materialien umfasst, ausgewählt aus der Gruppe umfassend chemische Verbindungen, Arzneimittel, organische Polymere, Farbstoffe, Peptide, Proteine, rekombinante Proteine, DNA, Teile von DNA Strängen, RNA, Mikroorganismen, Säugetierzellen, Stammzellen, eine Schicht aus gefärbtem oder fixiertem Gewebe, eine Schicht aus lebendem Gewebe und funktionelle Trägermedien wie Nährstoffe und anderes lebenserhaltendes Material.

9. Verfahren gemäss irgendeinem der Ansprüche 1 bis 8, worin das Empfangssubstrat Teil einer medizinischen Vorrichtung, einer elektronischen Vorrichtung, einer optischen Vorrichtung oder einer elektromechanischen Vorrichtung ist.

10. Verwendung des Verfahrens gemäss irgendeinem der Ansprüche 1 bis 8 zum direkten Abscheiden und/oder Schreiben von hybridem Nanokompositmaterial auf ein Substrat.

11. Verwendung gemäss Anspruch 10, worin das Substrat Teil einer medizinischen Vorrichtung, einer elektronischen Vorrichtung, einer optischen Vorrichtung oder einer elektromechanischen Vorrichtung ist.

## Revendications

1. Procédé de synthèse et/ou formation assistée par laser de matériaux nano-composites hybrides et dépôt direct sans contact et/ou écriture de ceux-ci sur une surface d'un substrat récepteur, comprenant les étapes consistant à:
- fournir une ou plusieurs sources d'énergie laser pour produire une énergie laser;
- fournir une lentille de focalisation;
- fournir un substrat de réception, dans lequel le substrat de réception est positionné à l'opposé de la source d'énergie laser;
- fournir une cible inorganique opaque au faisceau laser, dans laquelle la cible inorganique opaque au faisceau laser est positionnée entre le substrat récepteur et la source d'énergie laser et dans laquelle la cible inorganique opaque au faisceau laser comprend une couche organique déposée sur le côté arrière de la cible inorganique opaque au faisceau laser faisant face au substrat de réception, ladite couche organique étant en contact direct avec ladite cible inorganique opaque au faisceau laser, et ladite couche organique étant constituée d'un matériau ayant des propriétés physiques et/ou chimiques distinctes du matériau cible inorganique opaque au faisceau laser;
- fournir un support pour maintenir ladite cible inorganique opaque au faisceau laser à une distance fixe par rapport audit substrat de réception;
- positionner la cible inorganique opaque au faisceau laser ayant la couche organique en relation espacée avec la ou les plusieurs sources d'énergie laser de sorte que l'énergie laser provenant de ladite ou desdites sources d'énergie laser soit dirigée à travers la lentille de focalisation pour frapper directement la cible inorganique opaque au faisceau laser comprenant la couche organique à l'emplacement cible défini pour perforer la cible inorganique opaque au faisceau laser audit emplacement cible et créer une projection de gouttelettes fondues de matériau inorganique; dans lequel ladite projection traverse la couche organique et lesdites gouttelettes inorganiques fondues effectuent l'ablation du matériau organique, formant ainsi une projection de matériau nano-composite hybride contenant un matériau inorganique provenant de la cible inorganique opaque au faisceau laser et un matériau organique de la couche organique, dans laquelle ladite projection de matériau nano-composite hybride est dirigé vers le substrat de réception et ledit matériau nano-composite hybride est transféré et déposé à un emplacement défini sur le substrat de réception;
- répéter les étapes de positionnement et de frappe de la cible inorganique opaque au faisceau laser à l'emplacement cible successif, exposant ainsi la cible inorganique opaque au faisceau laser audit emplacement cible successif défini à la ou aux sources d'énergie laser de sorte que le matériau nano-composite hybride soit successivement déposé et/ou écrit à des emplacements cibles successifs définis du substrat récepteur.

2. Procédé selon la revendication 1, dans lequel le procédé est commandé par un ordinateur.

3. Procédé selon les revendications 1 ou 2, dans lequel ledit procédé est mis en oeuvre dans des conditions ambiantes ou à des conditions sous vide.

4. Procédé selon l'une quelconque des revendications 1 à 3, dans lequel la source d'énergie laser est un laser pulsé.

5. Procédé selon l'une quelconque des revendications 1 à 4, dans lequel le substrat de réception comprend une surface non planaire.

6. Procédé selon l'une des revendications 1 à 5, dans lequel le substrat récepteur est réalisé dans un ou plusieurs matériaux sélectionnés dans le groupe comprenant le verre chimiquement fonctionnalisé, le verre revêtu de polymère, le quartz, l'hydrogel naturel, l'hydrogel synthétique, le verre non revêtu, le verre revêtu de nitrocellulose, le silicium, le verre, les plastiques, les métaux, les polymères, les semi-conducteurs et les céramiques.

7. Procédé selon l'une quelconque des revendications 1 à 6, dans lequel la cible inorganique opaque au faisceau laser est constituée de n'importe quel matériau inorganique sélectionné dans le groupe comprenant les métaux, les alliages métalliques, les oxydes métalliques, les diélectriques, les semi-conducteurs.

8. Procédé selon l'une quelconque des revendications 1 à 7, dans lequel la couche organique comprend un ou plusieurs matériaux organiques ou bioactifs sélectionnés dans le groupe comprenant des composés chimiques, des médicaments, des polymères organiques, des colorants, des peptides, des protéines, des protéines recombinantes, de l'ADN, des portions de brins d'ADN, de l'ARN, des micro-organismes, des cellules de mammifères, des cellules souches, une couche de tissu coloré ou fixé, une couche de tissu vivant et des éléments de support fonctionnels tels que des nutriments et d'autres matériaux de maintien de la vie.

9. Procédé selon l'une quelconque des revendications 1 à 8, dans lequel le substrat récepteur fait partie d'un dispositif médical, dispositif électronique, dispositif optique ou dispositif électromécanique.

10. Utilisation du procédé selon l'une quelconque des revendications 1 à 8 pour le dépôt direct et/ou l'écriture de matériaux nano-composites hybrides sur un substrat.

11. Utilisation selon la revendication 10, dans laquelle le substrat fait partie d'un dispositif médical, dispositif électronique, dispositif optique ou dispositif électromécanique
